(19) Europäisches Patentamt
European Patent Office
Office européen des brevets

(11) **EP 2 881 870 B1**

(12) **EUROPEAN PATENT SPECIFICATION**

(45) Date of publication and mention
of the grant of the patent:
**06.04.2016 Bulletin 2016/14**

(51) Int Cl.:
***G06F 17/30*** *(2006.01)* ***H03M 7/30*** *(2006.01)*

(21) Application number: **14192703.8**

(22) Date of filing: **11.11.2014**

(54) **DATA COMPRESSION METHOD**

DATENKOMPRESSIONSVERFAHREN

PROCÉDÉ DE COMPRESSION DE DONNÉES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.12.2013 US 201314098706**

(43) Date of publication of application:
**10.06.2015 Bulletin 2015/24**

(73) Proprietor: **SAP SE**
**69190 Walldorf (DE)**

(72) Inventors:
• **Bhatnagar, Vidur Shailendra**
**69190 Walldorf (DE)**
• **Verma, Sudhir**
**69190 Walldorf (DE)**

(74) Representative: **Richardt Patentanwälte PartG mbB**
**Wilhelmstraße 7**
**65185 Wiesbaden (DE)**

(56) References cited:
**US-A1- 2010 030 796    US-A1- 2013 151 567**
**US-B1- 7 496 589**

## Description

### Field of the invention

The present disclosure relates to data compression methods and a corresponding computer system and storage medium.

### Background and related art

The amount of data collected and analyzed in various technological as well as economical fields is growing rapidly. The amount of data that needs to be stored requires a growing amount of storage space whose acquisition and maintenance generates costs. In addition, the steadily increasing amount of data slows existing analytical processes and programs, because more data needs to be loaded into memory for performing a data analysis or search. Often, data may have to be transmitted over a network before it can be analyzed.

Databases have traditionally used data compression models to make data easily consumable. In general, the major barrier in data compression is that, as the compression ratio increases, so does the complexity; a higher compression ratio often means that it is more difficult to decompress the data. Many conventional compression algorithms, such as null suppression, Huffman, and the like may provide 50 to 85% compression rates, but may be complex and the decompression of data may be a time intensive and computationally expensive process. In contrast, more lightweight (i.e., less computational demanding) compression techniques such as runlength compression, delta encoding, and the like, may not reach the above mentioned compression rates.

An example of the prior art is found in US 2013/0151567 A1 (Ellison Lawrence J et al.), containing the features of the preamble of the independent claims.

### Summary

It is an objective of the present invention to provide for an improved data compression method and system as specified in the independent claims. Embodiments of the invention are given in the dependent claims. Embodiments of the present invention can be freely combined with each other if they are not mutually exclusive.

In one aspect, the invention relates to a computer-implemented data compression method. The method comprises:

- providing a dictionary, the dictionary comprising a plurality of data records; each of said data records is stored in a memory element whose size is sufficiently large to store the longest one of the data records of the dictionary; for example, in case the dictionary comprises 1012 records, each record being a String or an integer value of 3-345 alphanumerical characters, each data record is stored in a memory element that is sufficiently large to store a record being 345 alphanumerical characters long;
- computing a mean of the lengths of the data records of the dictionary; for example, the number of alphanumerical characters of all records above mentioned dictionary may be summed up and divided by 1012;
- computing a standard deviation of the lengths of the data records of the dictionary; for example, the standard deviation may be calculated by using the computed mean as the expected value of the data record length and the standard deviation may indicate the deviation from said expected value;
- determining a deviation threshold, the deviation threshold indicating a maximum allowable deviation of a data record length from a mean data record length; for example, the deviation threshold may be read from a configuration or may be received via an interface from a user or from a client application program; the unit of the deviation threshold may be specified in standard deviations; for example, a deviation threshold K may be a predefined numerical value being larger than 0; for example, K could be 1, 2, 3 or 4.0, whereby K could indicate the number of standard deviations that the actual length of a data record may be larger than a mean data record length;
- calculating a threshold data record length from the computed mean, the computed standard deviation and from the determined deviation threshold; for example, the unit of the threshold data record length may be a data record element number, e.g. a number of alphanumerical characters; for example, a threshold data record length "LT" may be calculated by summing up the calculated mean m and the product of the standard deviation s computed for said dictionary and the deviation threshold K according to the formula LT=m+K*s; in some embodiments, the result of this step is rounded to the next upper integer value according to LT=round(m+K*s);
- splitting the dictionary into a minor dictionary and a major dictionary, the major dictionary selectively comprising the ones of the data records whose lengths are below or equal to the calculated threshold data record length, the minor dictionary selectively comprising the ones of the data records whose lengths are larger than the calculated threshold data record length;

- storing the data records of the major dictionary in a first array of further memory elements, whereby the size of each further memory element is fitted to the memory space consumed by a data record of the calculated threshold data record length; and
- storing the data records of the minor dictionary in a second array of still further memory elements, whereby the size of each still further memory element is fitted to the memory space consumed by the longest one of all data records of the dictionary.

Said approach may be advantageous, because a high compression ratio is provided by splitting the dictionary in the major and minor dictionary as described, while said compression and also the search in said two separate dictionaries still does not consume excessive computer resources. Thus, the I/O (input/output) overhead involved with loading a dictionary for search and data retrieval may be significantly reduced and hence the method may be suitable for I/O bound applications. Often, a few "outlier database records" which are very long cause a significant waste of storage space because the same memory space needs to be reserved for all other dictionary records in order to allow a quick, offset-based access to individual data records of the dictionary. Said storage space is wasted because the majority of records may consume only a fraction of said reserved space. However, by applying the above method, data may be stored in a highly compressed form.

In addition, the method may provide the benefit of reduced processing costs because the major and/or minor dictionary may be loaded into the memory for doing a search of a query term on the minor or major dictionary rather than the dictionary. In some embodiments, the dictionary may be erased from the memory after having loaded the minor and major dictionary into the memory.

In a further beneficial aspect, the comparison of data record length for doing the splitting and the calculation of a mean and a standard deviation can be executed quickly, because it is a numerical operation.

According to embodiments, the method further comprises using the minor and major dictionary instead of the dictionary for performing a search and/or for providing the data records to a client application, e.g. via a network connection. In some embodiments, the dictionary may be erased from the memory after the minor and major dictionary were created. In addition, or alternatively, data records stored in an original vector of data records (that may comprise transactional data records and thus may comprise one or more of the data records in multiple copies) which were previously mapped to respective records of the dictionary may be remapped to respective data records contained in the major or in the minor dictionary.

According to embodiments, the determination of the deviation threshold comprises:

- determining a plurality of different candidate deviation thresholds; for example, a set of integer values and/or floating point numbers for a parameter CK (candidate deviation threshold) may be read and retrieved from a configuration or may be created and calculated randomly, e.g. by means of a random number generator; for example, said plurality of different candidate deviation thresholds may consist of the following five values: ["1", "2", "3", "4.0" and "4.5"];
- calculating, for each of said candidate deviation thresholds, a candidate threshold data record length from the computed mean, from the computed standard deviation and from the determined candidate deviation threshold; the unit of the candidate threshold data record length may be, for example, a data record element number e.g. number of alphanumerical characters; for example, a candidate threshold data record length "CL" may be calculated for a particular candidate deviation threshold CK by summing up the calculated mean m and the product of the standard deviation s computed for said dictionary and said candidate deviation threshold CK according to the formula CL=m+CK*s; in some embodiments, the result of this step is rounded to the next upper integer value according to CL=round(m+CK*s);
- determining, for each of said candidate deviation thresholds (CK), the number of data records that would be stored in a candidate major dictionary and in a candidate minor dictionary in case of using said candidate deviation threshold (CK) for splitting the dictionary into the candidate minor dictionary and the candidate major dictionary, and calculating a total size of a combination of said candidate major and minor dictionaries; Said calculation may be performed quickly e.g. by multiplying the number of data records contained in a split dictionary by the size of each memory element or data storage element used for storing a data record of said split dictionary, and by summing up the results obtained for all split dictionaries generated by the splitting of the dictionary; for example, in case the dictionary is split into two split dictionaries referred to as the "major dictionary" and the "minor dictionary", the size of the minor dictionary and the size of the major dictionary are summed up;
- ranking the candidate deviation thresholds, whereby the larger said total size of the candidate major and minor dictionary calculated for said candidate deviation threshold, the lower the rank; and
- selecting the one of the candidate deviation thresholds having assigned the highest rank as the deviation threshold.

This may be advantageous, as the deviation threshold used for splitting the dictionary may be optimized for each particular dictionary. Thus, the memory- and storage space required to store the dictionary records is minimized for many dictionary instances having a different distribution of the data record lengths.

According to embodiments, the method further comprises:

- obtaining a length of a query term; for example, the number of alphanumerical characters of the query term may be identified for obtaining the length of the query term;
- determining if the obtained length is larger than the calculated threshold data record length;
- if the obtained length is larger than the calculated threshold data record length, selectively searching the query term in the minor dictionary;
- if the obtained length is smaller or equal to the calculated threshold data record length, selectively searching the query term in the major dictionary.

Using the minor and major dictionaries for performing the search as specified may be advantageous, because in particular the data records stored in the minor dictionary can be retrieved very quickly, because often the minor dictionary will only comprise a small fraction of the data records of the dictionary. Also, the search time for the major dictionary may reduced, because the loading and transferring of the major dictionary to any instance performing the search is accelerated by the reduced amount of storage consumed by the records of the major dictionary and because the major dictionary will be smaller than the dictionary.

According to embodiments, the query term is received from a client device having submitted a request comprising the query term. The query term may be received and processed by a database management system (DBMS) or a plug-in or an application operatively coupled to the DBMS. The compression of the data may be executed by said DBMS or said plug-in or said application operatively coupled to the DBMS.

According to embodiments, all of the data records of the dictionary are unique. The method further comprises:

- generating the dictionary as a derivative of an original vector of data records, the original vector of data records comprising at least two identical ones of the data records; and
- generating a mapping, the mapping linking each unique data record in the dictionary to one or more identical data records in the original vector.

This may be advantageous, because the dictionary may comprise a unique set of data records. The original vector may comprise transactional data with multiple copies of the same data record. Thus, by mapping of such a redundant data vector to its derivative, non-redundant dictionary which is split into at least a minor and a major dictionary, it is possible to execute a quick search, e.g. for a query term, on the non-redundant dictionary via the minor and major dictionary as explained herein for some embodiments, and to map the search result to one or more data records of the original vector of data records. Thus, instead of searching a transactional data record directly, which could be slow because a large number of records may have to be loaded into the memory for performing the search, the minor or major dictionary may be searched and the results and the generated mapping may be used for identifying the data records in the original vector which are identical to one data record in the major or minor dictionary which matched the query term.

According to embodiments, the original vector of data records is a column of a database table of a column oriented in-memory DBMS. A column-oriented database serializes all of the values of a column together, then the values of the next column, and so on. Columns stores may have natural redundancy in data records due to a recurrence of data records or patterns. By applying the compression method of any one of the described embodiments on columns of column stores, i.e., using a column of a column store as the dictionary, the compression and de-compression of said column stores may be improved. In addition, the compression ratio compared to traditional row-oriented database systems or state of the art column-stores can further be increased. This may result in reduced storage needs, improved performance (for I/O intensive applications), and an increase in buffer pool/cache hit rate.

In the particular case of applying the integer encoding algorithm on STRING values for creating an integer vector, values of a column comprising data records of the STRING type are encoded as integers. Thus, a check for equality, during scans or join operations can be executed on integer parameters, which may be much faster than comparing STRING values. Furthermore, the resulting integer vector may be compressed using various techniques, like prefix encoding, run-length encoding, cluster encoding, and the like. In addition, the dictionaries themselves, e.g. the dictionary and each of its split dictionaries may be compressed through methods like delta encoding compression.

According to embodiments, the method further comprises:

- determining at least a further deviation threshold, the further deviation threshold being smaller than the deviation threshold; and
- calculating, for the further deviation threshold, a further threshed data record length from the computed mean, from the computed standard deviation and from the further deviation threshold.

The splitting of the dictionary comprises splitting the dictionary into the minor dictionary, the major dictionary and the further major dictionary. The minor dictionary selectively comprises the ones of the data records whose lengths are larger than the calculated threshold data record length and smaller than or equal to the maximum data record length of all data records of the dictionary. The further major dictionary selectively comprises the ones of the data records whose lengths are larger than the further calculated threshold data record length and whose lengths are below or equal to the calculated threshold data record length. The major dictionary selectively comprises the ones of the data records whose lengths are below or equal to the calculated further threshold data record length.

Generating tree or even more split dictionaries as a result of the splitting may be advantageous, as the storage consumption and also the search time in the split dictionaries may be further reduced by providing a more fine grained adaptation of the memory space or storage space to the length of the records contained in each of the split dictionaries.

According to embodiments, the method comprises storing the data records of the major dictionary in a first contiguous memory space and/or in a first contiguous non-volatile storage space. In addition, or alternatively, the method comprises storing the data records of the minor dictionary in a second contiguous memory space and/or in a second contiguous non-volatile storage space.

Storing the data in a contiguous memory space and/or a contiguous storage space may be advantageous, as the efficiency of the search is further increased: in respect to the contiguous storage space, a read-write head of a non-volatile storage device may not have to "jump" to different storage blocks. In respect to the contiguous memory space, the efficiency may be increased as any swapping operation may affect the whole split dictionary and an offset based addressing of the individual split dictionary elements starting from a base address may be made possible. According to embodiments, the method further comprises flagging each data record of the dictionary with a split dictionary-ID, the split-dictionary-ID being indicative of the minor dictionary in case said data record was stored in the minor dictionary, the split-dictionary-ID being indicative of the major dictionary in case said data record was stored in the major dictionary, each flag consisting of one or more bits.

In addition, or alternatively, the method comprises flagging each data record contained in an original vector with a split dictionary-ID. The dictionary merely comprises unique data records. The original vector is a version of the dictionary which comprises multiple identical data records. The split-dictionary-ID is indicative of the minor dictionary in case said data record of the original vector was stored in the minor dictionary. The split-dictionary-ID is indicative of the major dictionary in case said data record of the original vector was stored in the major dictionary, each flag consisting of one or more bits.

In addition, or alternatively, the method comprises adding to each integer value contained in an integer vector at least one extra bit, the at least one extra-bit acting as an identifier for the minor dictionary or for the major dictionary, the dictionary merely comprising unique data records which have been extracted from all string values contained in an original vector, the original vector comprising multiple identical data record instances, each integer value in the integer vector having been generated by applying an integer encoding function on a string value contained in the minor or major dictionary, the at least one extra bit added to one of the integer values being indicative of the minor dictionary in case said integer value was generated by the integer encoding function using a data record in the minor dictionary as input, the at least one extra bit being indicative of the major dictionary in case said integer value was generated by the integer encoding function using a data record in the major dictionary as input.

Using said flags and extra bits may be advantageous e.g. in the context of a multi-table join operation to be performed by a DBMS, whereby the dictionary and each of its split dictionaries (e.g. the minor and the major table) are stored in respective database tables. The flag consisting of only a few bits may be used as a JOIN criterion that can be evaluated highly efficiently and that can be used to dynamically and effi-ciently identify if data associated with a particular record should be retrieved from the major or from the minor dictionary.

According to embodiments, the method further comprises:

- providing a sequence of strings, the sequence of strings comprising a plurality of different string values and at least two identical string values;

  ◦ for example, the sequence of strings may consist of a string vector. Preferentially, the string values in the string vector are chronologically ordered; the chronological order may depend, for example, on the time of creating or modifying a data record in the string vector, a timestamp of a transaction having created or modified the data record, or the like. The data strings of the string vector may relate to respective transactions. The strings in the string vector may be stored therein redundantly in a chronological order that may be specified by the chronological order of the transactions having created or modified the respective strings;

  ◦ alternatively, the sequence of strings may be received in chronological order, e.g. upon a transactional data processing operation wherein said string value is processed or is generated as output; for example, a string value, e.g. the name of the city of a customer having placed an order, may be received dynamically (after the city names of thousands of other customers have already been received); the sequentially received strings may not be stored permanently but rather may immediately evaluated, to determine if said string is already contained in the dictionary or not;

- generating the dictionary as a derivative of the sequence of strings, the dictionary consisting of the unique string values of the sequence of strings, each unique string value being one of the data records of the dictionary;
- creating an integer vector from the sequence of strings by applying an integer encoding function on each string value in the dictionary, the integer encoding function being a function that generates, for each unique string value of the dictionary, a respective unique integer value; and by storing said unique integer value in one or more elements of the integer vector; an integer encoding function is a function wherein one input value of the string type corresponds to and is firansformed into exactly one unique output value of the integer type.

Applying integer encoding for creating the integer vector and using the integer vector for performing a query term search (after having encoded also the query term as en integer by the same integer encoding function) may reduce the memory and storage consumption in use case scenarios where a transactional vector needs to be searched, the time required to load a given number of integer values into memory or for communicating said integer values via a network will be smaller than loading or communicating the same number of STRING values.

According to some embodiments where the sequence of strings consists in a sequence of chronologically received individual strings, the generating the dictionary as a derivative of the sequence of strings may comprise, for each of the individually received strings in the sequence of strings:

Determining, if said individual string is already contained in the dictionary or one of the split dictionaries by searching the dictionary or one of the split dictionaries for a matching string contained in said dictionary or split dictionary;
If a matching string for said individual string is identified in the dictionary or one of the split dictionaries, using, by the integer encoding function, the integer value that was created by the integer encoding function for the matching string as the integer value to be output for said individual string;

If no matching string for said individual string is identified in the dictionary or one of the split dictionaries, adding the received individual string at the end of the dictionary or at the end of one of the split dictionaries, and applying the integer encoding function selectively on the string added at the end of the dictionary or the one split dictionary; receiving an integer value generated by the integer encoding function applied on the added string value; and adding the received integer value at the end of the integer vector. Thus, in case a known string value is received, the length of the integer vector may be increased by one while the length of the dictionary and the split dictionaries may remain constant. In case an unknown string value is received, the length of the integer vector may be increased by one and the length of the dictionary or one of the split dictionaries will also be increased by one. The output integer value may be identical to the index position of the element added to the dictionary or the split dictionary upon adding the unknown received string. In embodiments where the received unknown string is added to one of the split dictionaries rather than to the dictionary, the adding may depend on the length of the received string. Preferentially, the received individual string value is erased from memory and/or from a non-volatile storage medium after the additional integer value was added to the integer vector.
Said approach may be beneficial for multiple reasons: at first, it is possible to main-tain, update and store a transactional integer vector in memory and/or in a non-volatile storage medium without storing, in addition, the string vector. This may reduce memory and/or storage consumption. Only a non-redundant string-based dictionary and a redundant, transactional integer vector may be maintained. This is cheaper in terms of storage consumption, because integers usually consume less storage space than strings.
According to embodiments, the method further comprises:

- receiving a query comprising a query term;
- applying the integer encoding function on the query term, thereby creating a query integer value; for example, the applying of the integer encoding function could comprise searching the dictionary or one of its split dictionaries for the query term for identifying an index position of a matching string in the dictionary or split dictionary; said index position of the matching string value could be returned by the integer encoding function as the query integer value;
- performing a search of the query integer value on the integer vector; for example, the search on the integer vector may be executed in the integer vector instead of an original, transactional string vector for determining a count of matching data records;
- returning the number of the identified one or more matching string values.

Performing a search not on string values but rather on integer values may increase performance. Searches can be performed faster on Integers than on STRINGs, because a numerical comparison is usually computational less demanding.

According to embodiments, the string vector and/or the integer vector may be cached, i.e., stored in the main memory and/or in a non-volatile storage medium for further use, e.g. for performing a search for query terms received at a later moment in time.

According to embodiments, the method further comprises:

- determining a block size number, the block size number being an integer; the block size number is indicative of the number of data records in each logical block of data records of the integer vector after which a new logical block is identified; only the last identified block in the integer vector may comprise less data records than the block size number; For example, said integer may be 1000, 10.000, 1 million or the like. Thus, the block size number specifies the maximum allowed number of data records contained in a block; all logical blocks except the last one will comprise exactly the block size number of data records;

- logically splitting the integer vector after each contiguous sequence of determined block size number of data records, thereby creating a plurality of logical blocks of the integer vector;

- generating a block encoding vector, the block encoding vector comprising one encoding element for each of said logical blocks, each encoding element having assigned a respective one of the logical blocks; all said logical blocks comprise as many data records as specified by the block size number parameter. Only the last block of the block encoding vector may comprise less than said number.

- for each of the created logical blocks, determining a block type. The block type is one of:

    ○ a major block, wherein all integer values contained in a major block were created from any of the string values being stored in the major dictionary; or
    ○ a minor block, wherein all integer values contained in a minor block were created from any of the string values being stored in the minor dictionary; or
    ○ a mixed block, wherein at least a first one of the integer values contained in a mixed block was created from one of the string values being stored in the minor dictionary and wherein at least a second one of the integer values contained in the mixed block was created from one of the string values being stored in the major dictionary;

- for each of the determined logical blocks, storing the determined block-type-ID of said logical block into the one of the encoding elements assigned to said logical block; for example, the block-type-ID may be stored in the form of a two-digit binary value, e.g. "01", "10" or "11".

- obtaining the length of the query term for determining if said obtained length is larger than the calculated threshold data record length;

- if the obtained length is larger than the calculated threshold data record length, selecting the major block type as a skip-type;

- if the obtained length is smaller or equal to the calculated threshold data record length, selecting the minor block type as a skip-type; a skip type is a type of logical block which is skipped when performing a query on the integer vector acting as the dictionary or when performing a query on one of its split dictionaries for a particular query term;

- performing a search of the query integer value on the integer vector, thereby skipping all integer values being contained in a logical block of the skip-type.

Skipping blocks of potentially many thousand data records when performing a search may significantly accelerate the search. This may be particularly helpful in the context of transactional data, because transactional data may often comprise redundant data records and thus may be larger than dictionaries having unique data records. Thus, when the integer vector is used e.g. for determining the number of occurrences of a query term in a transactional data set, the traversal of the index vector may greatly be accelerated.

Thus, different types of search may be supported by embodiments of the invention: a STRING-based search may be accelerated by redirecting the search to the relevant split dictionary rather than the original dictionary. An integer-based search may be performed on an integer vector that may have been generated from a STRING vector. Said STRING vector and also the integer vector may comprise a redundant, e.g. transactional list of data records. Performing a search of the integer vector may be accelerated by means of a block encoding vector that allows skipping one or more logical blocks of the integer vector when performing a search directly on the integer vector.

According to embodiments, searches on multiple different data structures, e.g. the split dictionaries and the integer vector, are combined for performing a highly efficient search. For example, at first a STRING based search may be performed based on the split dictionary approach in one of the split dictionaries, e.g. the minor dictionary, in order to determine if the query term can be identified in a large data set at least once. If the split dictionary search does not return a match, the search may terminate. If the search in a split dictionary identifies a matching string, the index position of said matching string in the split dictionary may be used as an integer based new query term for searching the integer vector sequentially for all integer values having been generated by the integer encoding function which are identical to the integer based new query term. This may allow the quick identification of the number of occurrences of the original query term in an original data set from which both the split dictionaries as well as the integer vector were derived. The search in the integer vector may, according to embodiments, be further accelerated by evaluating a block encoding vector and by skipping one or more logical blocks of the integer vector when performing the sequential search on the integer vector. The skipping may use the number of the records in each logical block, the number of the consecutive blocks to be skipped and the fixed memory or storage size consumed by each record in the integer vector to automatically compute the memory or storage address of the first record of the next one of the logical blocks of the integer vector that shall not be skipped. Thus, in effect, by a combination of two or more of the data structures described herein, a synergistic effect is provided which allows for quickly identifying the number of occurrences of a query term in a huge data set comprising millions of transactional data records.

According to embodiments, the block types in the block encoding vector are specified in the form of a predefined number of bits assigned to each integer value of the integer vector; For example, the block types may be stored in a bit vector or bit array. Preferentially, the predefined number of bits is "2 bits". The selected skip type is also specified by the predefined number of bits, e.g. "2 bits"; the skipping of the integer values contained in a logical block of the skip-type comprises evaluating the selected skip type on the block- types by means of linear search within the block encoding vector. The linear search may be implemented as a comparison of bits being indicative of the block type of a block and of bits being indicative of the skip type. This may be advantageous as the comparison of a few bits, e.g. of two bits, may be performable very rapidly.

For example, the linear search within the block encoding vector may be executed instead of a linear search along all entries of the attribute/integer vector.

The method may comprise using the block size number and the number of consecutive logical blocks of the skip type for calculating the number of integer values in the integer vector that can be skipped and for calculating the index position of the first integer value in the next logical block in the integer vector not being of the skip-type. The processor may directly "jump" to said calculated index position instead of sequentially scanning all integer values in the integer vector. Thus, the processor may "directly" access a particular data record or data value stored at said index position. This may increase performance.

When a processor performing the compression method determines, based on the skip type of the block encoding vector that e.g. the next block of 10.000 records is of type "minor block", that the current skip type for the query term is also "minor block", and that the second next block of 10.000 records if of type "major block", the processor executing a search on the integer vector, may automatically jump to the first data record of the second next logical block, said block being of the "major block type".

According to embodiments, the skipping of one or more logical blocks comprises calculating an offset by multiplying a number of consecutive logical blocks to be skipped with the block size number; directly jumping to the integer vector element whose index is calculated as the sum of the index of the currently evaluated integer vector element and the calculated offset. Thus, the processor, when skipping one or more logical blocks when performing a search, may directly jump (without performing a sequential search) to the integer vector element of the next logical block which is not of the skip-type. The jumping is possible because the processor "knows" the number of data records contained in each block and also "knows" the index of the currently evaluated integer vector element. As the memory size reserved for each data record in the integer vector is identical for all data records of the integer vector, the processor may easily calculate the jump address, i.e., the address of the first data record of the next logical block not being of the skip-type, and jump to said jump address. Thus, the search index may automatically be increased by the block size number or a multifold thereof, thereby skipping one or more blocks of the integer vector during the search and thus increasing search performance.

According to embodiments, the determining of the block size number comprises determining a plurality of candidate block size numbers. For each of the candidate block size numbers, the method comprises logically splitting the integer vector for creating a plurality of logical blocks comprising said candidate block size number of integer values, generating a respective block encoding vector and determining a block type for each of said created logical blocks of said block encoding vector as described before. For each of the candidate block size numbers, a performance cost is computed. The performance cost is calculated as:

$$BEV\_Performance\_Cost$$
$$=(Total\_Major\_Dictionary\_Blocks+Total\_Mixed\_Dictionary\_Blocks)*Major\_Dictionar$$
$$y\_Count + (Total\_Minor\_Dictionary\_Blocks+Total\_Mixed\_Dictionary\_Blocks$$
$$)*Minor\_Dictionary\_Count \text{ or as a derivative of said } BEV\_Performance\_Cost \text{ value,}$$

◦ wherein BEV_Performance_Cost is the performance cost;
◦ wherein Total_Major_Dictionary_Blocks is the total number of logical blocks of major block type that is obtained when using said candidate block size number for the logical splitting;
◦ wherein Total_Mixed_Dictionary_Blocks is the total number of logical blocks of mixed block type that is obtained when using said candidate block size number for the logical splitting;
◦ wherein Totai_Minor_Dictionary_Blocks is the total number of logical blocks of minor block type that is obtained when using said candidate block size number for the logical splitting;
◦ wherein Major_Dictionary_Count is the total number of data records of the major dictionary that is obtained when using said candidate block size number for the logical splitting;
◦ wherein Minor_Dictionary_Count is the total number of data records of the minor dictionary that is obtained when using said candidate block size number for the logical splitting;

The determining of the block size number further comprises ranking the computed performance costs, wherein the lower the performance costs, the higher the rank; and using the candidate block size number having the highest rank as the determined block size number.

This may be advantageous, because the above specified formula allows estimating the performance costs that should be expected when using a particular block size number given a particular length distribution of the data records in the dictionary. By doing the calculation and estimation for multiple candidate block size numbers, the optimal or at least almost optimal block size number for a given data record length distribution may be automatically determined.

According to embodiments, the determining of the block size number is executed for each of a plurality of candidate deviation thresholds as described already for embodiments of the invention. The method comprises calculating, for each of the candidate deviation thresholds, the total size of the minor and major dictionary that would be created when using the current candidate deviation threshold; the higher the computed total size, the higher the combined cost score; and calculating, for each of a plurality of candidate block size numbers, performance costs. For example, the performance costs may be calculated as described already for embodiments of the invention. Thereby, a combined cost score is calculated for each evaluated pair of candidate block size number and candidate deviation threshold; the higher the computed performance costs calculated for a particular candidate block size number, the higher the combined cost score. The method further comprises selecting the pair of candidate deviation threshold and candidate block size number corresponding to the lowest combined cost score. Thus, the combined cost score may reflect the ability of a particular combination of parameters such as candidate threshold data record length, candidate block size number or the like, that will yield good results both in terms of CPU consumption (upon compressing or decompressing data) as well as in terms of storage space consumption (when storing the data). To give a simple example, the combined cost score may be a two-value score consisting of the calculated total size and the calculated performance cost. The two scores could be normalized to fit into a predefined scale, e.g. between 0 and 1, and could be summed up. Thus, the higher the total predicted size for the split dictionaries and the higher the performance costs, the higher the combined cost score. More complex calculations of the combined cost score may also be used which may also take into account a preference of a user to reduce CPU load or memory consumption. According to embodiments, the user is provided with an interface for enabling the user to manually specify and modify the share the performance costs and/or the calculated total size of the split dictionaries have when the combined cost score is calculated. Thus, the user may adapt the scoring in dependence on his or her individual requirements in respect to data compression as well as performance.

In a further aspect, the invention relates o a non-transitory storage medium comprising computer-interpretable instructions, whereby the instructions, when executed by a processor, cause the processor to execute a method according to any one of the previous embodiments.

In a further aspect, the invention relates to a computer system comprising a processor and a main memory. The processor is configured for:

- providing a dictionary comprising a plurality of data records, each of said data records being stored in a memory element whose size is sufficiently large to store the longest one of the data records of the dictionary;
- computing a mean of the lengths of the data records of the dictionary;
- computing a standard deviation of the lengths of the data records of the dictionary;
- determining a deviation threshold, the deviation threshold indicating a maximum allowable deviation of a data record length from a mean data record length;
- calculating a threshold data record length from the computed mean, from the computed standard deviation and from the determined deviation threshold;
- splitting the dictionary into a minor dictionary and a major dictionary, the major dictionary selectively comprising the ones of the data records whose lengths are below or equal to the calculated threshold data record length, the minor dictionary selectively comprising the ones of the data records whose lengths are larger than the calculated threshold data record length;

- storing the data records of the major dictionary in a first array of further memory elements, whereby the size of each further memory element is fitted to the memory space consumed by a data record of the calculated threshold data record length; and

- storing the data records of the minor dictionary in a second array of still further memory elements, whereby the size of each still further memory element is fitted to the memory space consumed by the longest one of all data records of the dictionary.

**Definitions:**

A 'dictionary' as used herein is a set of data records, whereby each data record may consist of one or more data values. Preferentially, the set of data records is unique, but in some embodiments the dictionary may comprise one or more copies of the same data record. For example, the dictionary may comprise transactional data in said embodiments. Preferentially, the dictionary consists of a set of unique data records. A dictionary can be implemented, for example, as a vector or an array or as a database table column or the like. The data records of a dictionary may be strings, integers, or other data types.

A 'split dictionary' as used herein is a dictionary which selectively comprises a subset of the data records of a source dictionary after said source dictionary was split according to a splitting criterion. Said splitting criterion could be, for example, the data record length of the source dictionary.

A 'memory element' as used herein is a section of the memory, e.g. a section of a RAM. A memory element may be, for example, a section of the memory acting as a container for storing data of an element of a vector. For example, a memory element can be a container for storing a single data record or data value corresponding to the data content of a respective vector element. The size of a memory element may be specified, for example, in bytes or bits. The memory element may, for example, be identified by a base address and an index position (also referred to as "offset"), the base address being a memory address where the first element of said vector is stored, the index position being indicative of the position of the vector element that uses said memory element for storing its data content.

The expression 'a memory element is fitted to the memory space consumed by a particular data record' may, for example, mean that the size of the memory section that is reserved for acting as the memory element is chosen such that said memory section is of sufficient size to store said data record, but not any larger given the constraints of the IT-infrastructure used. For example, in some database manage-ment systems, some data types may be of an obligatory minimum size. In case the particular data record is smaller than said obligatory minimum size, the fitted memory space is identical to said obligatory minimum size. In case the particular data record is larger than said obligatory minimum size, the size of the memory element will be identical to the size of said particular data record. it may even be slightly bigger in case memory can only be reserved for comparatively large units of memory. The data records to be stored in a memory element may consist, for example, of only a single data value, e.g. a string or integer.

A 'deviation threshold' as used herein is a threshold value indicating a maximum allowable deviation of a data record length from a mean data record length. For example, the deviation threshold may be specified not as an absolute value, but as a relative value, e.g. a percentage value specified in relation to a mean data record length or a number of standard deviations specified in relation to a mean data record length. This may allow the specification of the deviation threshold already at a time when the reference of the deviation, e.g. the mean length of the records of a dictionary, is not known. It may also be specified in the form of a numerical value being indicative e.g. of the number of standard deviations relative to an expected value that may be considered as a split criterion for splitting a dictionary into multiple split dictionaries.

A 'threshold data record length' as used herein is an indicator of the length of a data record, whereby said lenth may act as a split criterion for splitting a dictionary into two or more sub-dictionaries, also referred to as "split" dictionaries. For example, the threshold data record length may be a number. Said number may be indicative of the number of alphanumerical characters of a data record of the STRING or INTEGER type.

A 'vector' as used herein is a data structure consisting of a set of items arranged along a single dimension, e.g. arranged in a single column or row. A 'string vector' is a vector configured for solely storing data records of STRING type. An 'integer vector', also referred herein as 'attribute vector', is a vector configured for solely storing data records of INTEGER type.

An 'array' as used herein is a vector of predefined number of elements. In some embodiments, the elements of an array occupy a contiguous storage space or a contiguous memory space.

An 'index position' as used herein is an identifier of the position of a particular 'item' (or 'element') within a linear data structure comprising multiple items. For example, the index position '3' of a vector of 10 vector elements identifies the third element and its data content starting from a start element '1' of said vector. If the memory or storage size reserved for each vector element is known and constant and if the index position of a vector element is given, the processor at a particular position within said vector may directly access ('jump') to said particular vector element instead of scanning the vector elements sequentially. The direct access may be performed by using said index position information for determining the jump address.

A 'integer encoding function' as used herein is a function that generates, for each unique input String, a unique output data value of integer type. Thus, as a result there exists an unambiguous 1:1 relationship of an input data record and an output data record. According to embodiments, the integer encoding function is a bijective function.

A 'block encoding vector' as used herein is a vector, whereby each element of said vector corresponds to a logical block of an integer vector. Each element may comprise meta data on its corresponding logical block, e.g. the type of said logical block ('minor block type', 'major block type', 'mixed block type').

**Brief description of the drawings**

In the following embodiments of the invention are explained in greater detail, by way of example only, making reference to the drawings in which:

| | |
|---|---|
| FIGS. 1A and 1B | illustrate schematic diagrams of example systems for data compression and search, in accordance with an example embodiment; |
| FIG. 2A | illustrates a table showing example master metadata, in accordance with an example embodiment; |
| FIG. 2B | illustrates a table showing an example city dataset; |
| FIG. 3A | illustrates an example attribute vector and a dictionary; |
| FIG. 3B | illustrates the splitting of the dictionary table of FIG. 3A into two split dictionaries based on the length of unique strings, in accordance with an embodiment; |
| FIG. 3C | shows a block encoding vector which may store information for logical blocks of integer values within an integer vector, in accordance with an embodiment; |
| FIG. 4 | illustrates a table showing an example master metadata table for a split dictionary, in accordance with an example embodiment; |
| FIGS. 5A and 5B | show distribution plots of example large datasets for a cities and names dictionary, respectively, in accordance with an example embodiment; |
| FIG. 6 | is a block diagram of an example apparatus for generating and utilizing a split dictionary, in accordance with an example embodiment; |
| FIG. 7 | is a flowchart for a first method for determining a deviation threshold, in accordance with an embodiment; |
| FIG. 8 | is a flowchart for a second method for determining a deviation threshold, in accordance with an embodiment; |
| FIG. 9 | illustrates an example integer vector ('attribute vector'), in accordance with an embodiment; |
| FIG. 10 | is a flowchart for a method for generating a block encoding vector, in accordance with an embodiment; |
| FIG. 11 | is a flowchart for a method for creating split dictionaries using a compression-oriented approach, in accordance with an embodiment; |
| FIG. 12 | is a flowchart for a method for creating split dictionaries using a performance-oriented approach, in accordance with an example embodiment; |
| FIGS. 13A and 13B | illustrate a flowchart for an example method for executing an exact string-matching query of a split dictionary, in accordance with an example embodiment; |
| FIGS. 14A-C | illustrate a flowchart for an example method for executing a wildcard string-matching query of a split dictionary, in accordance with an example embodiment; |
| FIG. 15A | shows how a percentage savings in memory may vary with the choice of the number of standard deviations considered for the city dataset of FIG. 3A; |
| FIG. 15B | shows how a percentage savings in memory may vary with the choice of the number of standard deviations considered for the names dataset; |
| FIG. 15C | shows how a percentage increase in performance may vary with the choice of the number of standard deviations considered for the city dataset; |
| FIG. 15D | shows how a percentage increase in performance may vary with the choice of the number of standard deviations considered for the names dataset; |
| FIG. 15E | shows a comparison of the time required to execute a search query; and |
| FIG. 16 | is a block diagram of a computer processing system within which a set of instructions, for causing the computer to perform any one or more of the methodologies discussed herein, may be executed. |

**Detailed description**

The description that follows includes illustrative systems, methods, techniques, instruction sequences, and computing program products that embody example embodiments of the present invention. In the following description, for purposes of ex-planation, numerous specific details are set forth in order to provide an understand-ing of various embodiments of the inventive subject matter.

Generally, methods, systems, apparatus, and computer program products for generating and processing dictionary tables are disclosed. In one example embodiment, dictionary tables are compressed through the use of statistical estimation tech-niques in order to reduce an amount of unused storage space allocated to the dictionary table. In one example embodiment, techniques to improve integer vector query performance without losing the record identifier (e.g., row/record-id) are disclosed. The disclosed techniques may preserve the ability to directly access elements of the dictionary tables without increasing the utilization of computing resources. In the following, the integer vector will also be referred to as 'attribute vector' (AV).

Multi-Tiered Enterprise Computing Systems

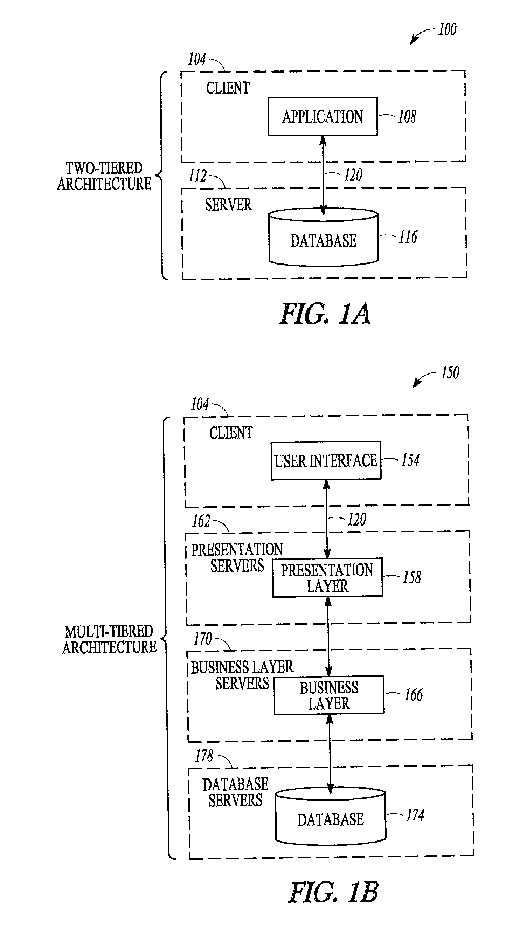

**FIGS. 1A and 1B** illustrate schematic diagrams of example systems 100, 150 for utilizing data dictionaries, in accordance with an example embodiment. Traditional client-server systems may employ a two-tiered architecture such as that illustrated by system 100 in **FIG. 1A.** Application 108 executed on the client 104 of the two-tiered architecture may be comprised of a monolithic set of program code including a graphical user interface component, presentation logic, business logic and a network interface that enables the client 104 to communicate over a network 120 with one or more servers 112. A database 116 may be maintained on the server 112 that provides non-volatile or "persistent" storage for the data accessed and/or processed by the application 108.

The application 108 may comprise a "business logic", e.g. some analytical program logic, some manufacturing control logic, some machine control logic, or any other kind of program logic performing some data processing tasks. Said "business logic" may be implemented based on rules governing the underlying business process (or other functionality) provided by the application 108. The application 108 may also comprise a "presentation logic" which may specify the specific manner in which the results of the business logic are formatted for display on the user interface. The "database" 116 may include and/or be operatively coupled to a data access logic used by the business logic to store and retrieve data.

In response to limitations associated with the two-tiered client-server architecture, a multi-tiered architecture has been developed, as illustrated in **FIG. 1 B.**

In the multi-tiered system 150, the presentation layer 158, business layer 166 and database 174 may be logically separated from the user interface 154 of the application. These layers may be moved off of the client 104 to one or more dedicated servers on the network 120. For example, the presentation layer 158, the business layer 166, and the database 174 may each be maintained on separate servers (e.g., presentation servers 162, business layer servers 170 and database servers 178).

This separation of logical components and the user interface 154 may provide a more flexible and scalable architecture compared to that provided by the two-tiered model of the system 100 in FIG. 1A. For example, the separation may ensure that all clients 104 share a single implementation of business layer 166. If business rules change, changing the current implementation of business layer 166 to a new version may not call for updating any client-side program code. In addition, the presentation layer 158 may be provided, which generates code for a variety of different user interfaces 154, which may be standard browsers.

For example, consider the following query:

*SELECT COUNT (*) FROM Suppliers WHERE City='Delhi'.*

To execute the above query, a system may have a master metadata table working in conjunction with a database manager to store information like table name, column name, start address of the dictionary, width of the string column in the dictionary, total number of records in the dictionary, encoding integer width, and the like.

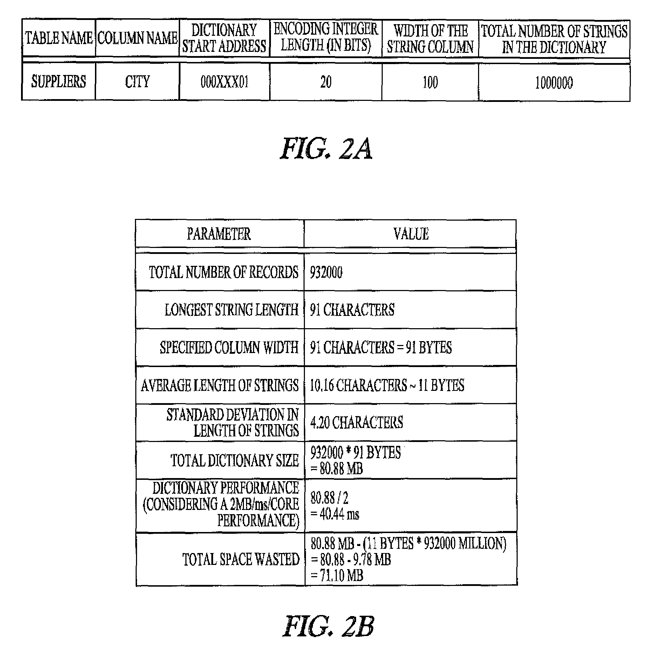

**FIG. 2A** illustrates a table showing example master metadata for a dictionary that shall be searched, in accordance with an example embodiment. The table of **FIG. 2A** comprises a title name, a column name, a start address for the corresponding dictionary, an encoding integer length (i.e., the number of positions of the integer values generated from the AV when applying the integer encoding function on the AV), a width of the string column (i.e., the width of a column having stored the String values of the String vector from which the AV was derived, and/or the width of a column having stored the values of the dictionary), and a count of the total number of data records (e.g. strings) in the dictionary. In the above SELECT query, the table name is "Suppliers" and the column is "City." To perform the query, the system may access the master metadata table depicted in Fig. 2A to determine the location of the dictionary table. In some

**12**

embodiments, the master metadata table may also be evaluated for finding the index position of the unique city string which equals "Delhi" in the dictionary. For example, the integer values generated by the integer encoding algorithm from the AV may act as integer identifier (ID) being indicative of the index position of the string value from which said integer values were respectively derived.

Split Dictionary Approach

The default width of a column in a table is often set such that it can accommodate the maximum length of a string. The memory allocations in a conventional dictionary are done as per the fixed column width (maximum length) defined in the database table. This may lead, however, to a waste of storage space, as strings which are shorter in length than the maximum length do not utilize the entire width of the col-umn. **FIG. 2B** illustrates a table showing an example city dataset, in accordance with an example embodiment. The column width allocated to the dictionary is 91 bytes (characters), leading to a total space requirement of 80.88 MB. The average length of the strings, however, is only 11 bytes, resulting in memory wastage of 87.90% (71.10 MB).

In one example embodiment, the unutilized storage space for shorter length strings may be reduced through a reorganization of the dictionary tables. The reorganization may comprise splitting the dictionary into two or more split dictionaries based on the length of unique strings of the dictionary, where each split dictionary table has a fixed column width that is fitted to the length of the longest data record said split dictionary is going to contain.

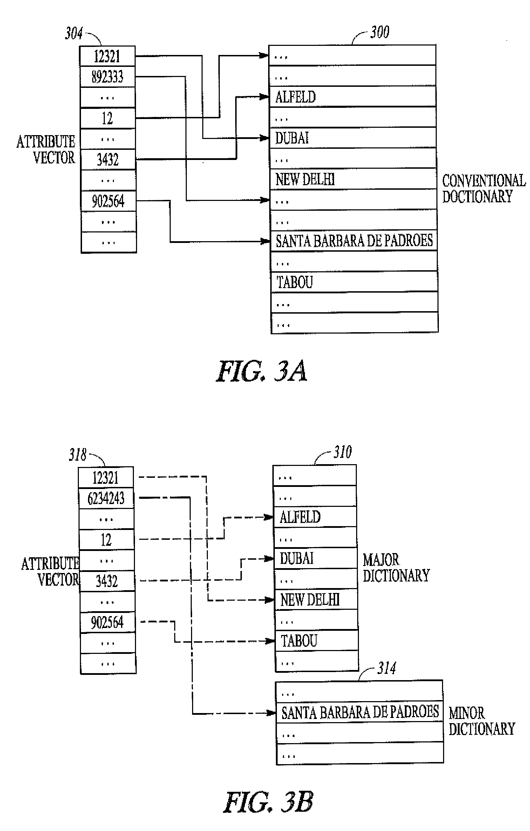

**FIG. 3A** illustrates an example conventional integer vector 304 and a dictionary 300, in accordance with an example embodiment. The dictionary 300 comprises a number of elements; each element may contain a different number of characters. **FIG. 3B** illustrates the splitting of the dictionary of **FIG. 3A** into two split dictionaries based on the length of unique strings of the dictionary. A major dictionary 310 may contain the elements from the dictionary 300 that are shorter than or equal to a dy-namically calculated length threshold value and a minor dictionary 314 may contain the elements from the dictionary 300 that are longer than said threshold value.

Thus, contrary to most of the current columnar database compression schemes focusing only on representing data more concisely, embodiments of the invention exploit the statistical information contained in the dictionary for dynamically determining a suited length threshold as the split condition.

The central limit theorem states that the distribution of the sum (or average) of a large number of independent, identically distributed variables will be approximately normal (regardless of the underlying distribution). Thus the lengths of millions of strings in a dictionary table can be safely assumed to be normally distributed. A result of a normal distribution is that most of the values may lie close to the mean due to the bell shape of the distribution curve. In statistics, the 68-95-99.7 rule, or the three-sigma rule, states that, for a normal distribution, nearly all the values lie within 3 standard deviations of the mean. Therefore, ideally, 99.7% of the total records of a dictionary should have lengths less than:

$$\textit{Mean of lengths} + (\textit{Constant} * \textit{Standard Deviation of lengths}) = m + K * s \quad (1)$$

In equation (1), constant (K) may be 3.

In one example embodiment, the mean and standard deviation in length of all the data records in the dictionary are computed. Based on these calculations, said dictionary, also referred to as 'master dictionary', may be split into two or more parts respectively referred to as 'split dictionary', one having a reduced column width to accommodate the majority (possibly 99.7%) of all of the strings with length less than the mean length plus a number (possibly "3") times the standard deviation length (henceforth referred to as the "major" dictionary table) and the other having a nonreduced column width to accommodate the minority (possibly 0.3%) of all of the strings with length greater than the mean length plus said number (e.g. "3") times the standard deviation length (henceforth referred to as the "minor" dictionary table).

The split criterion may be chosen such that strings in the minor table may have lengths that significantly deviate from the mean of lengths. This leads to a reduction in memory space needed to store the dictionary 300. Direct access may be maintained by mapping the records of the split dictionaries to the data records of the master dictionary. The major and minor dictionaries 310, 314 are individually maintained as sorted dictionaries that can directly be accessed and searched for better performance.

For example, a memory cost MK may be calculated for a particular deviation threshold K and a respective major and minor dictionary according to MK=NDRMAJOR*MEMJAJOR + NDRMAJOR*MEMJAJOR, wherein:

- NDRMAJOR= number of data records of the major dictionary;
- NDRMINOR= number of data records of the minor dictionary;
- MEMMAJOR= memory or storage space reserved for storing a data record of the major dictionary;
- MEMMINOR= memory or storage space reserved for storing a data record of the minor dictionary.

The higher the total sum of reserved memory or storage space MK, the higher the memory costs MK.

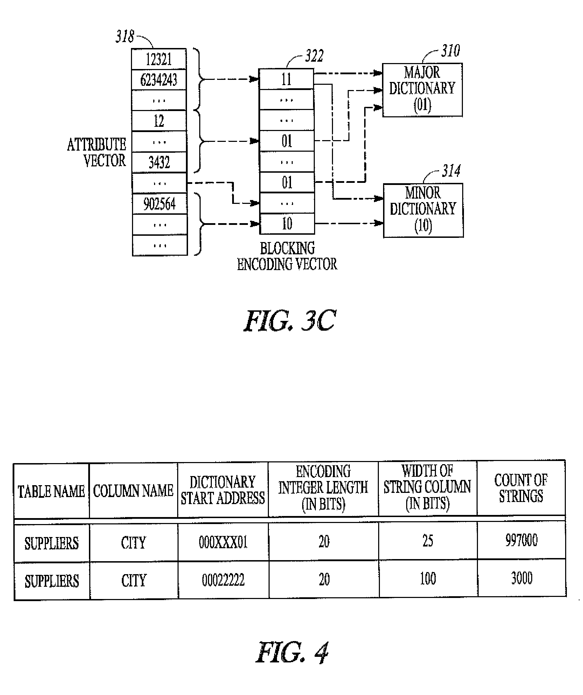

In one example embodiment, information for two dictionaries 310, 314 for a single table column may be maintained. For example, information for two dictionaries 310, 314 for a single table column may be maintained in a database manager. **FIG. 4** illustrates a table showing an example master metadata table for a split dictionary, in accordance with an example embodiment. The table of **FIG. 4** comprises a title name, a column name, a start address for each of the corresponding major and minor dictionaries 310, 314, an encoding integer length for each dictionary 310, 314, a width of the string column for each dictionary 310, 314, and a count of the total number of strings in the dictionary 300.

Dictionary Table Compression

The number of unique strings in a dictionary, which may be implemented, for example, as a dictionary table of a database, may be on the order of millions. In such instances, searching for a particular string in the dictionary may lead to performance degradation. To overcome this shortcoming, the dictionary tables may be compressed in some embodiments. For example, the dictionary tables may be compressed using delta encoding.

Challenges in Delta Encoding

Delta encoding algorithms may be used for compressing dictionary tables in terms of space requirements. Delta encoding may lead to degraded performance since compression creates varying column length vectors that complicate or prohibit the calculation of a jump address by means of offset information and a fixed column length. To improve the performance, a master metadata record may be created to store the variable lengths of each unique string. The stored variable lengths may be used to traverse the dictionary while reading table entries while, for example, searching for a particular string. The use of delta encoding for dictionary tables may, however, present various issues. For example, the reconstruction of the original record using the dictionary may be complex due to the variable length of the data records stored via delta encoding, as the address of the desired data records cannot be easily computed.

For particular queries, like substring matching, where the entire dictionary needs to be sorted, delta compression may lead to severe performance degradation as de-compression of data may be a complex procedure.

For queries involving an exact string search in the dictionary, generally, binary search algorithms may be implemented. If the dictionary is compressed using delta encoding, then traversing the compressed dictionary from one (middle) element to the next (middle) element in the search space becomes a challenge (as the computation of the same may be expensive). For example, consider that the search pointer is currently on the 11$^{th}$ dictionary element (sorted and compressed) and it needs to reach the 6$^{th}$ element to compare the query parameter with the string (since a binary search requirement is to split the search space in half). Based on this comparison, the search pointer either moves to the 3$^{rd}$ position or the 8$^{th}$ position for the next match. To calculate the memory address of the 6$^{th}$ record, it needs to get the length of the first 5 records and sum them to reach the beginning of the 6$^{th}$ element. This may be computationally expensive. Delta encoding may further complicate the update of new and unique string entries in the dictionary. In a simple dictionary, a new string may be simply inserted in between existing entries and the memory may be re-adjusted for the trailing strings. In the case of delta encoding, in addition to the memory re-adjustment, the delta/overlap length needs to be recomputed for the new entry and the immediate next string. If an index/metadata table is maintained, even that may have to be updated for all of the trailing strings (following the new entry).

In addition, since the records are now variable in length, the task of finding the next record entry may become more complex. Furthermore, null suppression, like delta encoding or any other approach that results in variable length columns/fields, may eliminate direct access to columns of records.

Challenges in Block Delta Encoding:

Some state of the art techniques such as "block delta encoding" provide direct access and still allow for a compression of data. In a block delta encoded dictionary, each unique string belongs to a "block" of a predefined number of strings, e.g. 16 strings. The strings of said "blocks" are compressed using the delta compression technique. To search a string in a "block" of a dictionary having been encoded by the "block delta encoding technique", a direct access to the blocks may be maintained using an index/metadata table, leading to a slight overhead in terms of space requirements. This may improve the performance of searching for a string in the dictionary as compared to pure delta encoding, but it may compromise the compression ratio. As the size of the dictionary increases, the size of the prefixed encoding parameters, namely, the overlap length and new string length, may increase in proportion. This may result in a larger memory being needed to store the block delta encoded dictionary. Consequently, a larger number of bits may be needed to address it in the metadata table. Even with this approach the challenge of having direct access to any string of a block delta encoded dictionary is not possible and compression too gets compromised. The challenge of having variable length strings within a delta encoded "block" or set of 16 strings remains and prohibits a direct access of individual strings. This may result in poor performance of the block delta dictionary approach compared to embodiments of the invention.

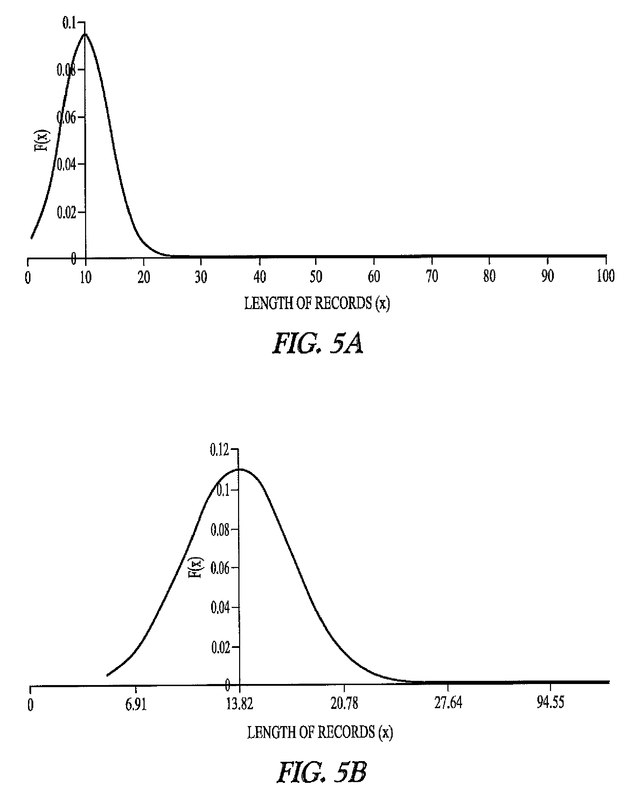

**FIGS. 5A** and **5B** show distribution plots of example large datasets for a cities and names dictionary, respectively, in accordance with an example embodiment. Both distribution plots satisfy the central limit theorem within acceptable variations for real life data. The total number of unique strings in both the datasets is nearly 1 million. In the case of the city dictionary, 1 % of the total strings (nearly 9762 strings) were assigned to the minor dictionary 310 at mean plus three times standard deviation.

Creation of Block Encoding Vector for the Attribute Vector

In one example embodiment, a block encoding vector is created for an integer vector, also referred to as 'attribute vector'. For example, consider a case in which 8 billion records may be stored, one for each individual of the world's population. The integer vector for the "name" column in this case may correspond to a predefined number of integer value positions and may need e.g. 20 bits to store an integer identifier. This may require a total of approximately 18.63 GB of memory space. If a query for a particular name is executed, such as:

SELECT COUNT (*) FROM Suppliers WHERE IVame='Robert',

the search space for the equivalent integer identifier of the "Name" parameter in the attribute vector is on the order of eight billion. Since the database system already knows the query term's length (e.g. 6 alphanumeric characters), the search space can be reduced by means of a split dictionary approach described above and/or by a block encoding vector based approach described in the following.

**FIG. 3C** shows a block encoding vector 322 which may store information for logical blocks of integer values (which may in some embodiments act as 'integer identifiers' for directly accessing a respective string value in a dictionary) within the integer vector, in accordance with an example embodiment. For this purpose, the integer vector is considered as 'N' contiguous logical blocks of fixed size (e.g., blocks containing a predefined number, e.g. 1024, of integer vector elements and respective integer values). The block encoding vector 322 entry for a logical block may specify whether said logical block contains integer identifiers solely from the minor dictionary or solely from the major dictionary or from both the major and minor dictionaries 310, 314. The system can then utilize this information for improved search performance.

In one example embodiment, the system creates three types of logical blocks, such as a major dictionary block, a minor dictionary block, and a mixed dictionary block (i.e., a logical block of the integer vector which contains integer values from both the major and minor dictionaries 310, 314). A 2-bit vector may be used for storing information related to a particular logical block of the integer vector in the block encoding vector 322. For example, in this vector, a value of '01' may represent a block containing only integer identifiers from the major dictionary 314, a value of '10' may represent a block containing only integer identifiers from the minor dictionary 310, a value of '11' may represent a block of the 'mixed block type' containing integer identifiers from both the major and minor dictionaries 310, 314, and the value of '00' may represent logical blocks of null values (in case a particular column allows null values).

In **FIG. 3C**, a dashed line represents major blocks, a single dotted line represents minor blocks, and a double dotted line represents mixed blocks. The logical block information is computed for each of the N logical blocks of the integer vector. For the example of the world's population described above, 7,812,500 logical blocks of 1024 integer values each may be created. The memory space needed to store the block encoding vector is about 1.86 MB (i.e., 7,812,500 two-bit vectors). In one example embodiment, only two types of blocks exist (e.g., a block which contains integer identifiers from both the major and minor dictionaries 310, 314 and a logical block which contains integer identifiers from only the major dictionary 314), then a 1-bit vector may be sufficient to store the block-related information and the memory space needed to store the block encoding vector is reduced further.

Continuing with the world's population example, suppose a query of the name 'Robert' is submitted. The name 'Robert' has a length of six characters corresponding, in the present example, to six bytes. The length of six bytes is less than the mean length plus three times the standard deviation length and the name 'Robert' is therefore located in the major dictionary 314 if the split criterion "mean + 3 standard deviations" was used for generating the major and the minor dictionary. Therefore, only logical blocks corresponding to the major dictionary 314 (two-bit vector equals '01') or corresponding to both dictionaries 310, 314 (two-bit vector equals '11') need to be searched; logical blocks corresponding to the minor dictionary 310 (two-bit vector equals '10') and corresponding to blocks which represent null values (two-bit vector equals '00') may be skipped. The block encoding vector information may be used to identify the cited logical blocks.

Performance Examples

Based on the combination of the types of blocks and the type of query, different scenarios may be contemplated to understand the performance improvements.

For example, in scenario #1, assume there are an equal number (approximately 47.5%) of major and minor dictionary blocks, and approximately 5% of the blocks are mixed dictionary blocks. The search space of the attribute vector will be equal to 47.5°/fl major blocks, 47.5% minor blocks, and 5% mixed blocks, irrespective of whether the query term belongs to the major or the minor dictionary 310, 314. Thus, instead of scanning the entire attribute vector of 18.63 GB, the search space is limited to 9.78 GB. Assuming a processing speed of 2 MB/ms/core, a performance gain of almost 47.5% is achieved.

For example, in scenario #2, assume there are an equal number (approximately 33.3%) of major, minor, and mixed dictionary blocks. The search space of the integer vector will be equal to 33.3% of major, minor, and mixed blocks, irrespective of the type of query parameter. Thus, instead of scanning the entire attribute vector of 18.63 GB, the search space is limited to 12.29 GB. Assuming a processing speed of 2 MB/ms/core, a performance gain of almost 34% is achieved.

For example, in scenario #3, assume there are an equal number (approximately 10-20%) of major and minor dictionary blocks, and approximately 70% of the blocks are mixed dictionary blocks. The query term belongs to the major (or minor) dictionary 310, 314. The search space of the attribute vector is limited to 70% of mixed dictionary blocks and 10-20% major (or minor) dictionary blocks. The limiting factor for performance gain in this case is the size of the mixed dictionary. Therefore, any variations in the performance are only due to the size of the remaining major and minor dictionary blocks. The performance gain in this case is between 10 and 20% depending on the size of the major and minor dictionary blocks and whether the search is in the major or the minor dictionary 314, 310.

For example, in scenario #4, assume there are a higher number (e.g., approximately 70%) of either major or minor dictionary blocks and the remaining blocks (minor/major and mixed dictionary blocks) are each approximately 10% to 20% of the total. The query term belongs to the major (or minor) dictionary 314, 310 and there are a higher number of major (or minor) dictionary blocks only. The search space of the attribute vector is limited to the 70% major (or minor) blocks and 10% mixed blocks. The performance gain in this case is about 20% as compared to the full attribute vector scan, as the search space is reduced to 14.90 GB.

Alternatively, the query term belongs to the minor (or major) dictionary 310, 314, but there are a higher number of major (or minor) dictionary blocks. The search space is effectively limited to 20% minor (or major) blocks and 10% mixed blocks. This may be the best scenario in terms of performance, as only 5.59 GB of memory space needs to be scanned, instead of 18.63 GB. This may lead to a performance gain of almost 70%, and the gain can further increase as the size of corresponding blocks decrease.

The following inferences may be drawn from the above examples:

1)The overall system performance gain may be constant in scenarios #1 and #2, regardless of the combination of different types of queries (searching on major or minor dictionary 310, 314), as the search space may be equally reduced in both the cases.

2) Within scenarios #1 and #2, the former is better for overall performance as the mixed dictionary blocks may be very low in number.

3) In scenarios #3 and #4, with varying combinations of different types of queries, approximately 10 to 70% performance gain may be attained.

Overall, a small memory allocation of 1.86MB (0.00976% of the overall attribute vector) for the block encoding vector 322 may lead to a performance gain of 10% to 70% (based on the combination of different types of queries).

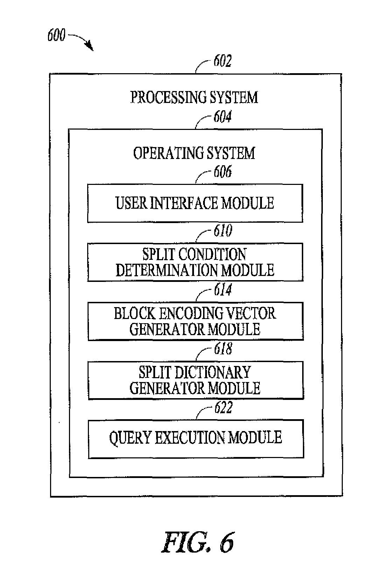

**FIG. 6** is a block diagram of an example apparatus 600 for generating and utilizing a split dictionary, in accordance with an example embodiment. For example, the apparatus 600 may be used to generate and perform queries utilizing a split dictionary.

The apparatus 600 is shown to include a processing system 602 that may be implemented on a server 112, client 104, or other processing device that includes an operating system 604 for executing software instructions. In accordance with an example embodiment, the apparatus 600 may include a user interface module 606, a deviation threshold determination module 610, a block encoding vector generator module 614, a split dictionary generator module 618, and a query execution module 622.

The user interface module 606 may enable a user to enter a query and view query results.

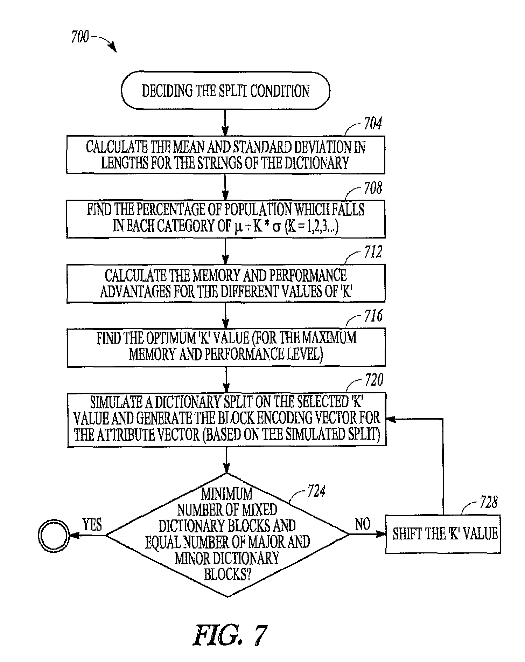

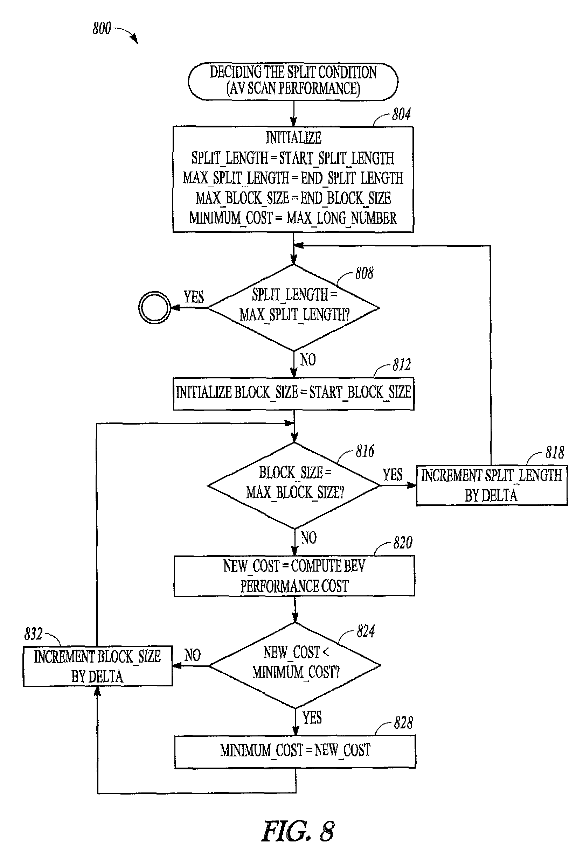

The deviation threshold determination module 610 may determine a deviation threshold, also referred to as a 'split condition", and may calculate a threshold data record length, also referred to as "split length", for splitting a dictionary 300 into two or more sub-dictionaries, also referred to as "split dictionaries". Said splitting is described more fully below in conjunction with **FIGS. 7** and **8**. For example, the deviation threshold or multiple candidate deviation thresholds may be predefined and stored in a configuration. The threshold data record length or one or more candidate threshold data record lengths may be calculated automatically, e.g. upon instantiating the database comprising the dictionary for which the (candidate) threshold data record length is calculated and/or upon each INSERT, UPDATE or DELETE operation performed on said dictionary and/or repeatedly upon a predefined time interval, e.g. one day or one hour, has lapsed.

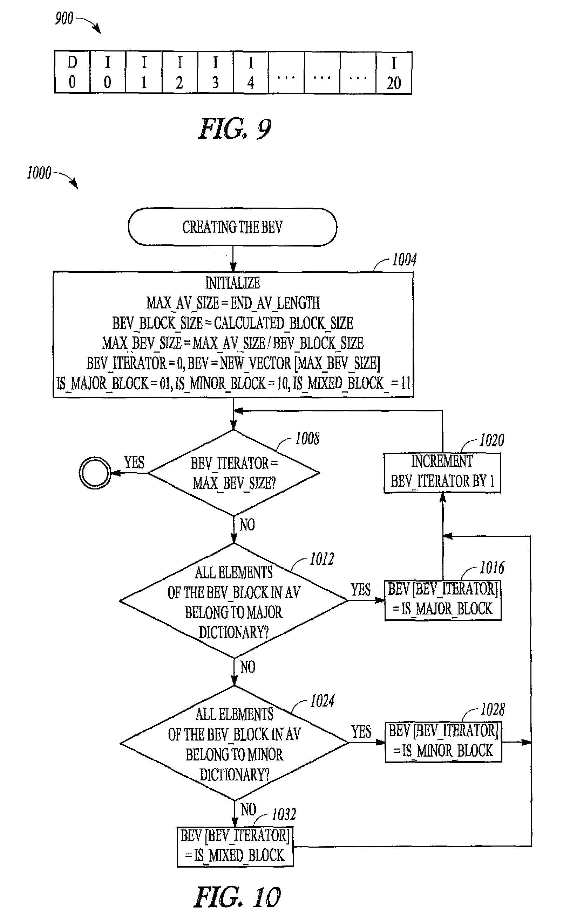

The block encoding vector generator module 614 may generate a block encoding vector 322, as described more fully below in conjunction with **FIG. 9**.

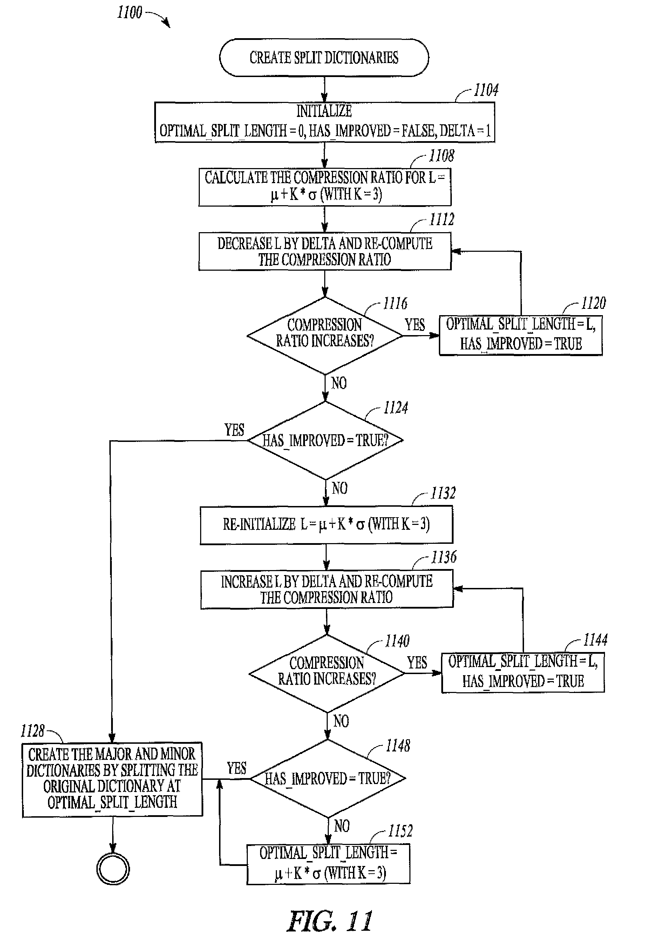

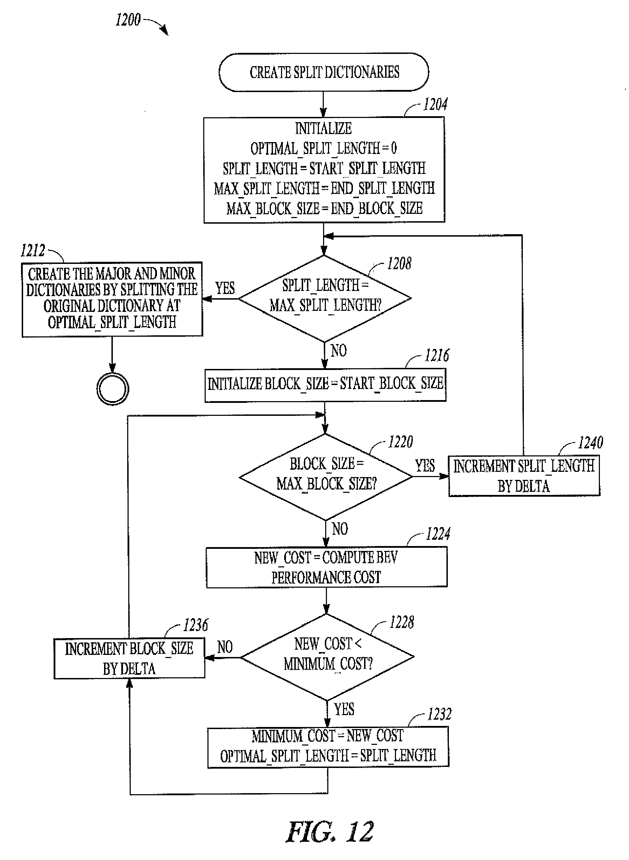

The split dictionary generator module 618 may generate a split dictionary, as described more fully below in conjunction with **FIGS. 11** and **12**.

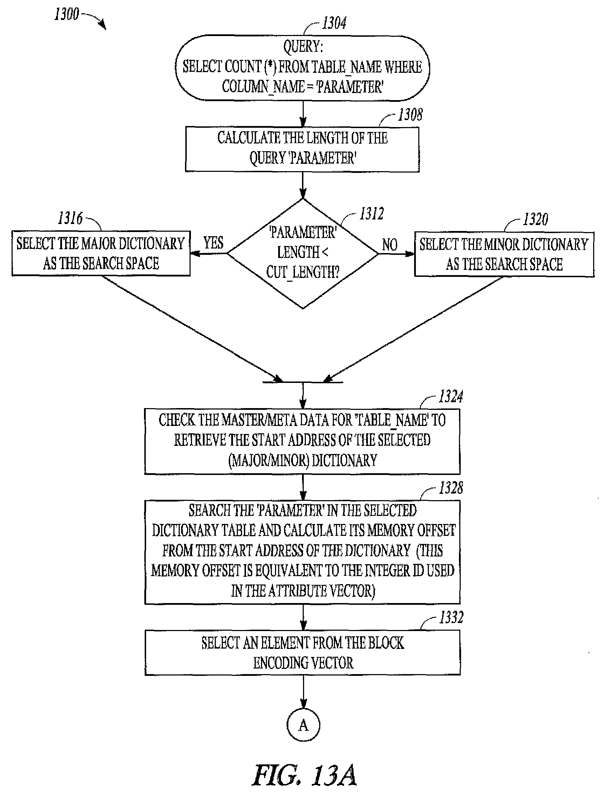

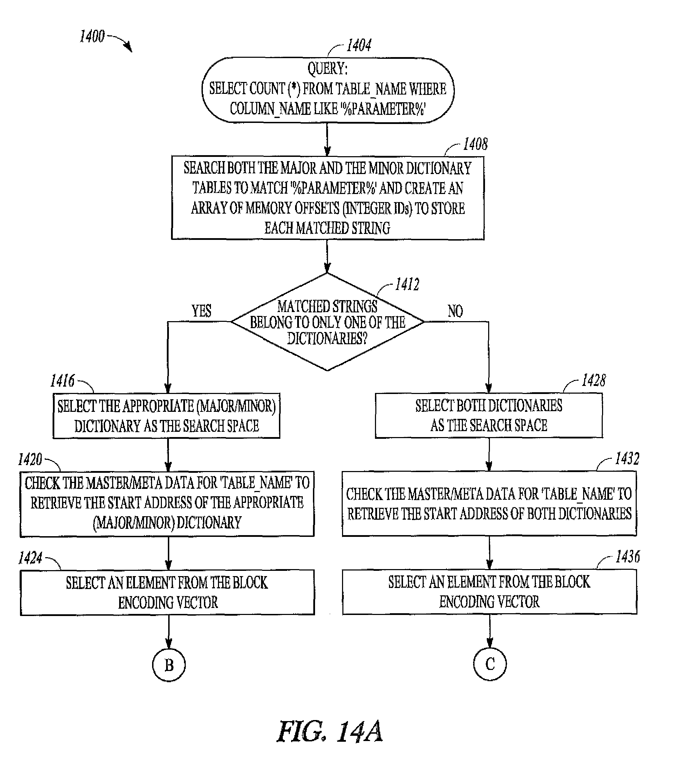

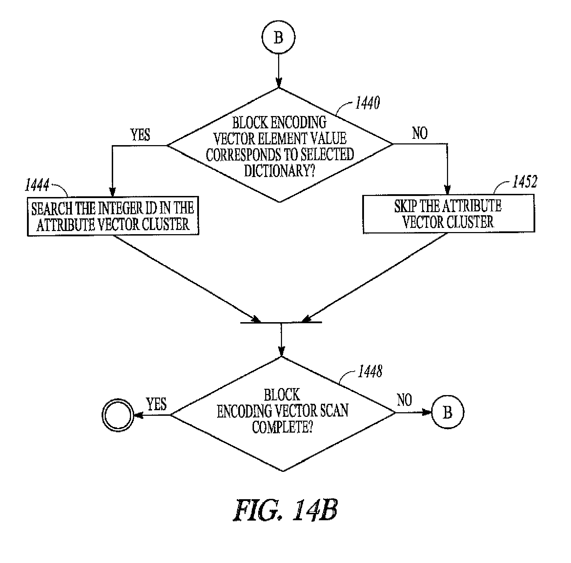

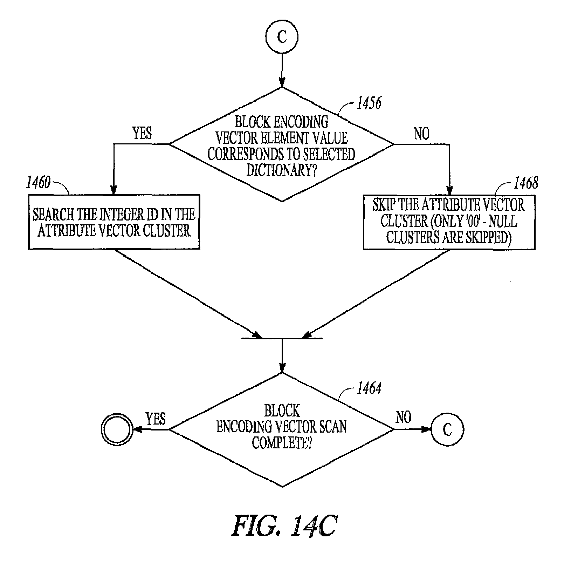

The query execution module 622 may execute a query comprising a query term, as described more fully below in conjunction with **FIGS. 13A-13B** and **14A-14C.**

Determining the Split Condition

To calculate a threshold data record length to be used as the split condition, at first, a deviation threshold is determined, e.g. by accessing a configuration. In addition, the mean length of the data records in the dictionary 300 and the standard deviation in these lengths is computed. These statistics may be computed for the one or more dictionaries contained in an in-memory database directly in said in-memory database. Alternatively, in certain situations (like a disk-based database system or batch loading - growing dictionary scenarios), the system utilizes the statistics with sampling data to estimate the mean and standard deviation of the data records of a dictionary. In one example embodiment, a sample set of data records may be taken from the dictionary through random sampling and used to estimate the mean length of all data records of the dictionary using the Z-test and the standard deviation of the data records of the dictionary using the Chi-square test.

1) Calculating the threshold data record length

In one example embodiment, using the calculated mean m of the length of the data records of the dictionary and using the calculated standard deviation s of said length in respect to said mean, the percentage of data records of the dictionary whose length is shorter or longer than the threshold data record length L may be found according to the formula:

$$L = m + K * s \qquad (2)$$

where K is the deviation threshold, e.g. a numerical value such as 1,2,3... Based on the above calculation, the following steps may provide a generic approach to determine the threshold data record length:

a) Based on the percentage of data records of the dictionary separated into different split dictionaries, the memory and performance advantages for different values of 'K' may be computed. For the city dataset dictionary, the generated statistics (mean and standard deviation) may be as shown in the table of **FIG. 2B**. Based on these statistics, the memory and performance benefits according to the different values of 'K' can be computed.

b) Once the optimum 'K' value (for memory and performance level) is found, the system may simulate a dictionary split (the actual split is still not done) on the optimum 'K' value and may generate the block encoding vector 322 for the integer vector (based on this simulated split).

c) Once the block encoding vector 322 is created, the system attempts to optimize the block encoding vector 322 to achieve scenario #1 (i.e., achieve a minimum number of mixed dictionary blocks and an equal number of major and minor dictionary blocks) as described above. This may be done by analyzing the current mix of different types of blocks and then shifting the K value so as to reach a mix closest to scenario #1. All said different K values for which said performance and memory benefits are calculated are also referred herein as "candidate deviation thresholds" CK;

d) Once the optimal block proportions are found, the system may split the dictionaries at this final level of 'K', with the cut length or "threshold record length" L of m + K * s.

**FIG. 7** is a flowchart for a method 700 for determining an optimal deviation threshold K and for calculating a corresponding threshold data record length, in accordance with an example embodiment. In one example embodiment, one or more of the operations of the method 700 may be performed by the deviation threshold determination module 610.

In one example embodiment, the mean and standard deviation of the lengths of the data records of the dictionary 300 may be computed (operation 704) and the percentage of the dictionary records that falls in each split dictionary generated based on a deviation threshold K for calculating a candidate threshold data record length L of L= m + K * s (for K = 1, 2, 3...) may be computed (operation 708). The memory and performance advantages for different values of K may be determined (operation 712) and the optimal value of K in regard to memory and performance may be determined (operation 716).

In one example embodiment, the dictionary split based on the optimal value of K taken from a plurality of candidate deviation thresholds CK may be simulated and the block encoding vector 322 for the attribute vector may be generated based on the simulated dictionary split (operation 720). A test may be performed to determine if a minimum number of mixed dictionary blocks and an equal number of major and minor dictionary blocks have been defined (operation 724). If a minimum number of mixed dictionary blocks and an equal number of major and minor dictionary blocks have been defined, the method may end; otherwise, the value of K may be shifted (operation 728), e.g. by increasing K by one or by selecting another predefined candidate deviation threshold CK as the new K, and the method may proceed with operation 720.

In one example embodiment, the optimal split length, i.e., the optima! threshold data record length, and block size number for a given integer vector AV may be determined by the following steps.

a) The system continuously reiterates over the AV with different threshold data record length ("split lengths") (e.g. from the candidate threshold record length CL having been calculated according to formula CL= m + CK * s).

b) For each split length, the system loops over a number of block size numbers (for, such as, from 1024 to 10240, at a step size of 1024) and re-generates the block encoding vector 322 for each block size number.

c) For each block encoding vector 322, a performance cost BEV-Performance-Cost, which is to be minimized, may be calculated according to the following formula:

$$BEV\_Performance\_Cost$$
$$=(Total\_Major\_Dictionary\_Blocks+Total\_Mixed\_Dictionary\_Blocks)*Major\_Dictionary\_Count + (Total\_Minor\_Dictionary\_Blocks+Total\_Mixed\_Dictionary\_Blocks$$
$$)*Minor\_Dictionary\_Count \text{ or as a derivative of said } BEV\_Performance\_Cost \text{ value},$$

◦ wherein BEV_Performance_Cost is the performance cost;

◦ wherein Total_Major_Dictionary_Blocks is the total number of logical blocks of major block type that is obtained when using said candidate block size number;

◦ wherein Total_Mixed_Dictionary_Blocks is the total number of logical blocks of mixed block type that is obtained when using said candidate block size number;

◦ wherein Total_Minor_Dictionary_Blocks is the total number of logical blocks of minor block type that is obtained when using said candidate block size number;

◦ wherein Major_Dictionary_Count is the total number of data records of the major dictionary;

◦ wherein Minor_Dictionary_Count is the total number of data records of the minor dictionary.

FIG. 8 is a flowchart for a second method 800 for deciding a deviation threshold, in accordance with an example embodiment. The method 800 may enhance integer vector AV performance while selecting the block size number and a threshold data value length also referred to as "split length". In one example embodiment, one or more of the operations of the method 800 may be performed by the deviation threshold determination module 610.

In one example embodiment, the following variables Split_Length, Max_Split_Length, Max_Block_Size, and Minimum_Cost may be initialized (operation 804) as follows:

- the threshold data record length ("Split_Length") L may represent a threshold data record length and may be initialized to L= m + K * s with K=0 or; For example, K may be configured by user;
- the Max_Split_Length may be initialized to 100;
- the Max_Spiit_Length may act as a termination criterion;
- the Max_Block_Size may indicate a block size number of the integer vector and may be initialized to 1024; it may act as a termination criterion; and
- the Minimum_Cost variable may represent the lowest performance costs having yet be calculated and may be initialized to the value of the Max_Long_Number, wherein the Max_Long_Number may be a very high number that can savely be assumed to be higher than any value calculated for the performance costs.

A test may be performed to determine if the Split_Length equals the Max_Split_Length (operation 808). If the Split_Length equals the Max_Split_Length, the method may end; otherwise, the variable Block_Size may be set equal to Start_Block_Size. For example, the variable Block_Size may be set equal to 1024 (operation 812). A test may be performed to determine if the variable Block_Size equals the Max_Block_Size (operation 816). If the variable Block_Size equals the Max_Block_Size, the variable Split_Length may be incremented by the value Delta (depending on the choices of K (L= m + K * s)) (operation 818) and the method may proceed with operation 808; otherwise, the performance cost (New_Cost) of the block encoding vector 322 may be computed (operation 820).

A test may be performed to determine if the variable New_Cost is less than the variable Minimum_Cost (operation 824). If the variable New_Cost is less than the variable Minimum_Cost, then the variable Minimum_Cost is set equal to the variable New_Cost (operation 828) and the method may proceed with operation 832; all parameters such as the Split_Lenght (representing the threshold data record length) having been used for calculating said Minimum_Cost are stored as the currently identified optimum parameter values; otherwise, the method may proceed with operation 832.

During operation 832, the variable Block_Size may be incremented by the value Delta (e.g., the value 1024) and the method may proceed with operation 816.

Integer Encoding for Generating an Integer Vector

According to embodiments, the data records of the dictionary may consist of a unique set of STRING values. Said unique set of string values may have been derived from an original string vector comprising redundant STRING values. Such a redundant string vector may also be referred to as 'transactional', because the entries may be created upon a transactional event, like a money transfer, a booking of a ticket or the registration of a person for a particular service. For example, a database column for the first names of 1 million people having registered at a particular service will comprise many data records for common names such as 'Andy' or 'Susan'. Performing a count() operation on such a transactional string vector may be computationally demanding. Embodiments of the invention may provide for a more efficient count operation in transactional, redundant string vectors, by the following steps:

The string vector may be automatically evaluated by the DBMS or a plug-in or application program interfacing with the DBMS to extract all unique STRINGs contained in the STRING vector. Said extracted unique set of STRINGs is stored in a data structure comprising a set of contiguous memory elements or storage elements. For each of said memory elements or storage elements, the same fixed amount of memory or non-volatile storage space is reserved. Said data structure may be used as the dictionary. Said dictionary may be split for generating two or more split dictionaries as described above. Preferentially, a mapping is generated during the extraction of the unique set of STRINGS which assigns each unique STRING value of the dictionary (or of a split dictionary) to one or more index positions of the String vector where an identical String value is stored. (This mapping is depicted for the integer vector which is generated later as a derivative of the string vector in Figures 3A and 3B, but it is already created for mapping strings of the string vector to unique strings in the dictionary).

In addition, an integer vector is created that comprises as many elements as the original string vector. Thus, the integer vector may also comprise redundant, transactional data values. However, at each index position i of the integer vector, an integer value is stored that is computed by applying an integer encoding function on a String value stored at the same index position i of the STRING vector.

According to preferred embodiments, the integer encoding algorithm operates as follows:

All string values of the dictionary may be traversed sequentially or by means of a binary search if the dictionary is sorted. For each currently accessed string value of the dictionary, the index position within the dictionary comprising the currently accessed string value is determined. Said determined index position is used as the output integer value generated by the string encoding algorithm for said currently accessed string value. As the string values occur only once in the dictionary, the index position of any string value within said dictionary can safely be assumed to be unique for said particular string value. The mapping may be evaluated to identify one or more index positions of elements of the (transactional) string vector comprising a string value that is identical to the currently accessed string value of the dictionary. Then, the output integer value, i.e., the index position of the currently accessed string value, is stored at said one or more identified index positions of the integer vector. Thus, when the dictionary is completely traversed, the integer vector is filled with integer values which are identical to the index positions of the corresponding string values of the string vector within the dictionary. A string value in the string vector 'corresponding' to an integer value in the integer vector has the same index position in the string vector as the integer value in the integer vector.

To give a concrete example, a transactional string vector comprising 19782922 string values is provided, with 1000 unique strings in it. An index vector is created with 19782922 empty elements. The string vector may comprise the string value 'Andy' at index positions 4, 4009 and 3000827 of the string vector. The dictionary comprises a single string value 'Andy' at position 113. The mapping created upon the generation of the dictionary maps the index position 113 of the dictionary to index position 4, 4009 and 3000827 of the string vector. The integer encoding algorithm traverses the dictionary. When the String 'Andy' at position 113 is evaluated as the currently accessed string value, its index position in the dictionary, i.e., "113" is returned as the output of the string encoding algorithm for the input value "Andy". The mapping is evaluated for identifying the index positions 4, 4009 and 3000827 of the string vector mapped to the currently accessed string value of the dictionary. Then, the output integer value "113" is stored at the index positions 4, 4009 and 3000827 of the integer vector. Said steps are repeated for each string value of the dictionary, thereby filling up all 19782922 elements of the integer vector with dictionary index positions of corresponding string values.

Thus, the integer vector, also referred herein as 'attribute vector', may simply store the dictionary index positions, which are indicative of the memory offset or storage offset of the strings in the dictionary 300, as "integer identifiers".

According to one embodiment, the index positions of the dictionary are determined and stored in the integer vector.

According to other embodiments being based on the split-dictionary approach, the index positions of the split dictionaries, e.g. the minor and the major dictionary, are used. In this case, to avoid confusion, an extra bit may be added to the integer value output by the integer encoding function, whereby the extra bit indicates if the index position was obtained from the minor dictionary or from the major dictionary. The pros and cons of the extra bits are discussed in detail in the chapter "Allocating an Extra Bit to the Integer Values to identify one of the Split Dictionaries"

According to a still further embodiments being based on the split-dictionary approach, the integer identifiers for both the major and the minor dictionaries are continuous. For example, the major dictionary may comprise 990 strings and comprise index positions 1 - 990 while the minor dictionary may comprise 10 strings stored at index positions 991 -1000. Thus, the first index position of the minor dictionary may be identical to the last index position of the major dictionary increased by one. Thus, the integer encoding function traversing the major and the minor dictionary may perceive both split dictionaries as one contiguous vector, e.g. one continuous table. For example, as shown in the table of **FIG. 4**, the integer vector may store the integer identifiers from 1 to 997,000 for the major dictionary and may store the integer identifiers from 997001 to 1000000 for the minor dictionary. In such a case, the integer identifiers for the major dictionary 314 are simply the index positions, i.e., the memory offset (also referred to as 'storage offset in case the dictionaries are stored in a non-volatile storage medium) of the strings in the major dictionary 314, and the integer identifiers for strings in the minor dictionary 310 are calculated as:

$$\textit{Integer IDs for minor table} = \textit{Number of total strings in major dictionary} + \textit{Memory}$$

$$\textit{offset in minor dictionary}$$

When a new unique string is inserted in either the major or minor dictionary 314, 310, the memory offsets ("index positions") of the existing strings change, as new strings may be added in between existing strings in order to keep the dictionary sorted. This may lead to a large number of updates in the integer vector, as the entire set of integers below this new entry may need to be updated by one. However, the maintenance overhead of using continuous integer identifiers is comparatively low when using in-memory DBMS like SAP HANA of SAP AG of Walldorf, Germany. In one example embodiment, the memory or storage space reserved for each data record of the string vector may be defined by the width of a database column acting as the string vector. To perform a query on the dictionary, values in the dictionary are traversed using integral multiples of the string column width specified in the master metadata table of said string vector in search of a query term.

According to embodiments, performing a search for a particular query term, e.g. 'Andy' and counting the number of its occurrence in a transactional string vector may be performed as follows:

The split dictionary approach is used for quickly identifying a matching entry 'Andy' either in the major or in the minor dictionary. In order to quickly identify the number of occurrences of 'Andy' in the transactional string vector, the index position of 'Andy' e.g. in the major dictionary is identified, e.g. "113". Then, in a next step, the identified index position "113" is used as a new query term for searching the integer vector. For each matching integer value "113" in the integer vector, a counter is increased. Finally, the counter is returned as a result being indicative of the number of occurrences of "Andy" in the string vector, which is identical to the number of occurrences of "113" in the integer vector. The search for "Delhi" mentioned in an example above would be executed analogously.

Allocating an Extra Bit to the Integer Values to Identify one of the Split Dictionaries

As illustrated in the table of **FIG. 2A**, according to embodiments, a predefined number of integer positions, which may correspond to a predefined number of bits, e.g. 20 bits, are reserved in memory and/or in a non-volatile storage medium per integer value in the integer vector ("attribute vector"). In one example embodiment, an extra bit may be added as a "flag" to specify in which split dictionary the string value from which said integer value was derived is stored. **FIG. 9** illustrates an example integer vector, in accordance with an example embodiment. For example, as illustrated in **FIG. 9**, the Do bit may be used as a selection variable for the split dictionaries 310, 314, where a value of 0 signifies that the major dictionary 314 comprises the respective string value and a value of 1 specifies that the minor dictionary 310 comprises the respective string value of the integer value having assigned said extra bit. The extra bit may be useful during dictionary updates, as the minor dictionary 310 does not get impacted with changes in the major dictionary 314 (and vice versa). Therefore, the extra bits of the integer values of the integer vector may allow, upon performing an INSERT, UPDATE or DELETE operation on a particular split dictionary, e.g. the minor dictionary, to selectively update the corresponding integer identifiers relating to the altered minor dictionary, not the integer identifiers of the unaltered, major dictionary.

Thus, using a major and minor dictionary forming a continuous index offset space has the advantage that no extra memory is needed for the extra bit, but may have a higher cost for dictionary updates. The second approach of using split dictionaries with independent index offsets and no extra bit in the encoded integer value may lead to efficient updates, but with an additional cost in terms of memory.

**FIG. 10** is a flowchart for a method 1000 for generating a block encoding vector 322, in accordance with an example embodiment. In one example embodiment, one or more of the operations of the method 1000 may be performed by the block encoding vector generator module 614.

In one example embodiment, the Max_AV_Size, BEV_Block_Size, Max_BEV_size, BEV_Iterator, Is_Major_Block, Is_Minor_Block, and Is_Mixed_Block variables may be initialized (operation 1004). For example, said variables may be initialized as follows:

- Max_AV_Size may be a constant that is initialized with the parameter End_AV_Length, whereby End_AV_Length is the total number of transactional records in the integer vector (e.g., one billion 1.000.000.000);
- BEV_Block_Size may represent the logical block size number, i.e., a number of data records per logical block of the integer vector, chosen for a current iteration and may be initialized to a predefined or calculated value referred in the figure as "Calculated_Block_Size" (e.g., 1000); the BEV_Block_Size may be set to one out of a plurality of predefined candidate block size numbers or to an optimal block size number having been calculated previously. Both types of block size numbers are represented by the parameter "Calculated_Block_Size" in the figure.

- Max_BEV_size may represent the maximum logical block number, i.e., the maximum number of logical blocks in the integer vector allowed, and may be used as a termination criterion; it may be initialized to Max_AV_size/BEV_Block_Size, e.g. 1.000.000.000/1000=1.000.000;
- BEV_Iterator may be a counter for the iterations to be performed and may initialized to zero,
- BEV may represent the "block encoding vector" and may be initialized to a new, empty vector according to: BEV = New_Vector[Max_BEV_Size],
- Is_Major_Block may be initialized to 01,
- Is_Miner_Block may be initialized to 10, and
- Is_Mixed_Block may be initialized to 11.

A test may be performed to determine if BEV_Iterator equals the Max_BEV_Size (operation 1008). If BEV_Iterator equals the Max_BEV_Size, the method may end; otherwise, a test may be performed to determine if all the elements of the BEV_Block in AV belong to the major dictionary 314 (operation 1012).

If all the elements of the BEV_Block in AV belong to the major dictionary, then BEV[BEV_Iterator] is set to Is_Major_Block (operation 1016) and the BEV_Iterator variable may be incremented by one (operation 1020). The method may then proceed with operation 1008.

If all the elements of the BEV_Block in AV do not belong to the major dictionary 314, a test may be performed to determine if all the elements of the BEV_Block in AV belong to the minor dictionary 310 (operation 1024). If all the elements of the BEV_Block in AV belong to the minor dictionary 310, then BEV[BEV_Iterator] is set to Is_Minor_Block (operation 1028) and the BEV_Iterator variable may be incremented by one (operation 1020). The method may then proceed with operation 1008.

If all the elements of the BEV_Block in AV do not belong to the minor dictionary 310, then BEV[BEV_Iterator] is set to Is_Mixed_Block (operation 1032) and the BEV_Iterator variable may be incremented by one (operation 1020). The method may then proceed with operation 1008.

**FIG. 11** is a flowchart for a method 1100 for creating split dictionaries using a compression-oriented approach, in accordance with an example embodiment. In one example embodiment, one or more of the operations of the method 1100 may be performed by the split dictionary generator module 618.

According to the empirical rule, almost 99% of records in the dictionary 300 should have a length less than $L = m + K * s$, where $K=3$ and L is the threshold data record length, also referred to as "split length". In one example embodiment, the compression ratio for the split dictionary approach at $L = m + K * s$ may be computed as:

(Original Dictionary Count * Original Dictionary Data Record Length) / (Major_Dictionary_Count * L + Minor_Dictionary_Count * Original Dictionary Data Record Length)

The value of L may then be reduced by delta, e.g. by 10 alphanumerical character positions, and the compression ratio may be re-computed. If the compression ratio increases, L may be decreased until it either becomes zero or the compression ratio value decreases instead of increasing. The L for the resulting compression ratio may be used to determine the optimal split length.

However, if after reducing L by delta, the compression ratio value decreases, then L may be increased by delta and the compression ratio may be re-computed. The value of L may be increased until the best compression ratio is found and the corresponding split length may be selected.

If, in both the cases of decreasing and increasing the L value by delta, the compression ratio decreases, then K=3 is the best case. The split length may then be set to L = m + 3 * s.

For the city dataset, the generated statistics (mean and standard deviation) are as shown in the table of **FIG. 2B**. Based on these statistics, the compression ratio (or memory saving percentage = 1 - 1/compression ratio) may be computed according to the different values of 'K', also referred to as "candidate" deviation thresholds CK.

In one example embodiment, the Optimal_Split-Length, Has_Improved, and Delta variables may be initialized (operation 1104). For example,

- the Optimal_Split_Length may represent the optimum split length ("threshold data record length") that is finally returned for L and that may be initialized to zero,
- Has_Improved may be initialized to "false", and
- Delta may be initialized to one.
- The compression ratio for the current L (i.e., Compression_Ratio_L) may then be calculated (operation 1108), where

$$Compression\_Ratio\_L = m + K * s.$$

L may be decreased by delta and the compression ratio for L may be re-computed (operation 1112).

A test may be performed to determine if the compression ratio has increased (operation 1116). If the compression ratio has increased, Optimal_Split_Length is set to L and Has_Improved is set to "true" (operation 1120). The method may proceed with operation 1112.

If the compression ratio has not increased, a test may be performed to determine if Has_Improved equals "true" (operation 1124). If Has_Improved equals "true", the major and minor dictionaries may be created by splitting the original dictionary at Optimal_Split_Length (operation 1128). The method may then end.

If Has_Improved equals "false", the compression ratio for L (i.e., Compression_Ratio_L) may then be reinitialized (operation 1132), where

$$Compression\_Ratio\_L = m + K * s.$$

L may be increased by delta and the compression ratio for L may be re-computed (operation 1136).

A test may be performed to determine if the compression ratio has increased (operation 1140). If the compression ratio has increased, Optimal_Split_Length is set to L and Has_Improved is set to "true" (operation 1144). The method may proceed with operation 1136.

If the compression ratio has not increased, a test may be performed to determine if Has_Improved equals "true" (operation 1148). If Has_Improved equals "true", the major and minor dictionaries may be created by splitting the original dictionary at Optimal_Split_Length (operation 1128). The method may then end.

If Has_Improved equals "false", Optimal_Split_Length is set to L = m + K * s, where K=3 (operation 1152). The method may proceed with operation 1128.

**FIG. 12** is a flowchart for a method 1200 for creating split dictionaries using a performance-oriented approach, in accordance with an example embodiment. **FIG. 12** shows the flow of the steps to attain optimized AV performance while selecting the block size number and the threshold data record length ("split length"). In one example embodiment, one or more of the operations of the method 1200 may be performed by the split dictionary generator module 618.

In one example embodiment, the system continuously iterates over the AV with different threshold data record length (for example, from 10 to 100, at a step size of 10). For each threshold data record length, the system loops over a number of block size numbers (for example, from 1024 to 10240, at a step size of 1024) and re-generates the BEV for each block size number. The aim is to reach scenario #1 described above. Therefore, for each BEV, a performance cost, which is to be minimized, is calculated according to the following formula:

$$BEV\_Performance\_Cost = (Total\_Major\_Dictionary\_Blocks + Total\_Mixed\_Dictionary\_Blocks) * Major\_Dictionary\_Count + (Total\_Minor\_Dictionary\_Blocks + Total\_Mixed\_Dictionary\_Blocks) * Minor\_Dictionary\_Count \text{ or as a derivative of said } BEV\_Performance\_Cost \text{ value,}$$

  ◦ wherein BEV_Performance_Cost is the performance cost;
  ◦ wherein Total_Major_Dictionary_Blocks is the total number of logical blocks of major block type that is obtained when using said candidate block size number;
  ◦ wherein Total_Mixed_Dictionary_Blocks is the total number of logical blocks of mixed block type that is obtained when using said candidate block size number;
  ◦ wherein Total_Minor_Dictionary_Blocks is the total number of logical blocks of minor block type that is obtained when using said candidate block size number;
  ◦ wherein Major_Dictionary_Count is the total number of data records (unique strings) in the major dictionary;
  ◦ wherein Minor_Dictionary_Count is the total number of data records (unique strings) in the minor dictionary;

In one example embodiment, the Optimal_Split_Length, Split_Length, Max_Split_Length, and Max_Block_Size variables may be initialized (operation 1204). For example, Optimal_Split_Length may be initialized to zero, Split_Length may be initialized to Start_Split_Length (e.g., 10), Max_Split_Length may be initialized to End_Split_Length (e.g., 100), and Max_Block_Size may be initialized to End_Block_Size (e.g., 1024).
A test may be performed to determine if Split_Length equals Max_Split_Length (operation 1208). If Split_Length equals Max_Split_Length, the major and minor dictionaries may be created by splitting the original dictionary at Optimal_Split_Length (operation 1212). The method may then end.
If Split_Length does not equal Max_Split_Length, Block_Size may be initialized to Start_Block_Size (e.g., 1024) (operation 1216).
A test may be performed to determine if Block_Size equals Max_Block_Size (operation 1220). If Block_Size equals Max_Block_Size, Split_Length may be incremented by Delta (operation 1240) and the method may proceed to operation 1208. If Block_Size does not equal Max_Block_Size, the BEV performance cost is computed and New_Cost is set to the computed BEV performance cost (operation 1224).
A test may be performed to determine if New_Cost is less than Minimum_Cost (operation 1228). If New_Cost is not less than Minimum_Cost, Block_Size may be incremented by Delta (operation 1236) and the method may proceed with operation 1220. If New_Cost is less than Minimum_Cost, Minimum_Cost is set to New_Cost and Optimal_Split_Length is set to Split_Length (operation 1232) and the method may proceed with operation 1236.
Either the compression-oriented approach or the performance-oriented approach work well in case the user has only a single goal to achieve, i.e., better compression or better performance. In most cases, however, the system administrator would want to achieve the best trade-off between compression ratio and performance of the system. In such a case, a threshold level can be defined for both the factors of compression and performance and the above steps can be adequately modified to decide the split length in light of the threshold levels.

Updating Multiple Dictionaries

In some example embodiments, enterprise database systems may not be frequently updated; only 5% of the dictionary data may change over time. This may make it easier to maintain a dictionary in sorted form.
A delta store may be maintained for fast write operations. Instead of directly updating the compressed data, which may be slow, faster uncompressed delta caches (known as L1-delta & L2-delta) may be maintained and may be write optimized. Write operations may only be performed on the delta storage. The changes may then be transferred to the main storage through a process called delta merge. In the case of dictionary compression, the dictionaries of two delta structures are computed (only for L1-delta) and sorted (for both L1-delta and L2-delta), and merged with the main dictionary on the fly.
For a split dictionary implementation, the insert and delete queries may still be made in the delta store only. The delta merge process, however, may need to be modified such that, instead of merging the delta dictionaries with the main dictionary, the merge is done to the appropriate dictionary (major or minor dictionary 314, 310) on the same premise of length of string being lesser than or greater than m + K * s. With changes in a dictionary, the database manager may need to be updated. For example, as shown in the table of **FIG. 4**, a unique string in the major dictionary 314 may be added at memory offset 150000 in the major dictionary 314. In the present example, this increases the size of the major dictionary 314 to 997001.

In the case of a split dictionary approach with continuous integer identifier mapping, this may affect all of the integer identifiers in the integer vector which are greater than 150000, i.e., from 150000 to 1000000. In the split dictionary approach with an extra bit for integer identifier mapping, this may only affect the major table entries in the attribute vector, i.e., from 150000 to 997001 (the minor table entries remain unchanged).

Frequency of Threshold Data Record Length Update

With updates in the dictionaries, the mean and standard deviation of lengths will change. According to embodiments, the system checks and updates the threshold data record length during the lean/idle time periods. Due to this update, a few of the data records of the dictionary may need to be shifted from either the major dictionary 314 to the minor dictionary 310 or vice versa, resulting in re-sorting of the reorganized dictionary. Also, according to embodiments, the integer vector needs to be updated for both the dictionaries 310, 314 since the integer IDs change in both the dictionaries 310, 314.

For the enterprise dataset, however, the dictionary data may not change for some time. Also, since the total number of records may be in the millions, the addition of a relatively few new strings may not highly influence the computed mean and/or standard deviation.

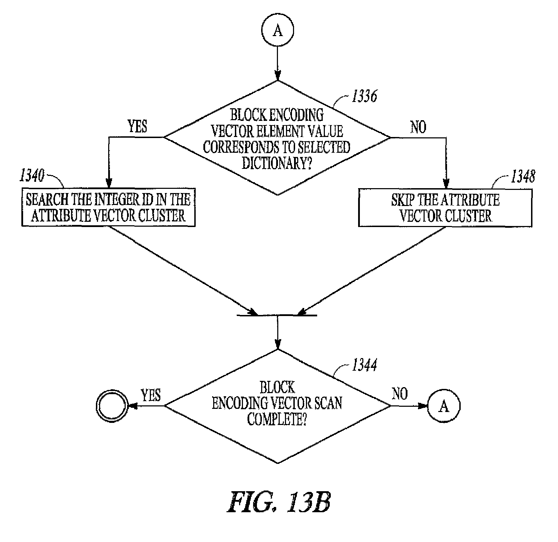

**FIGS. 13A** and **13B** illustrate a flowchart for an example method 1300 for executing an exact string-matching query of a split dictionary, in accordance with an example embodiment. In one example embodiment, one or more of the operations of the example method 1300 may be performed by the query execution module 622.

In one example embodiment, a Count (*) may be selected from the table "Table_Name" where Column_Name is set to 'Parameter' (operation 1304). The length of the query term 'Parameter' may be computed (operation 1308). A test may be performed to determine if the 'Parameter' query term length is less than the threshold data record length represented in parameter "Cut_Length" (operation 1312). If the 'Parameter' query term length is less than the Cut_Length, the major dictionary 314 may be selected (operation 1316) and the method may proceed with operation 1324; otherwise, the minor dictionary 310 may be selected (operation 1320) and the method may proceed with operation 1324.

In one example embodiment, the start address of the corresponding major or minor dictionary may be obtained (operation 1324). For example, a database manager may access a master metadata structure for "Table_Name" to retrieve the start address. The 'Parameter' may be searched for in the appropriate dictionary table and the corresponding memory offset from the start address of the dictionary may be computed (operation 1328). The memory offset is equivalent to the integer identifier used in the attribute vector.

An element may be selected from the block encoding vector 322 (operation 1332). The selected element may be tested to identify whether the selected element corresponds to the selected dictionary indicating that the corresponding logical block from the integer vector should be searched (operation 1336). If the selected element does not correspond to the selected dictionary, in other words, if the currently examined logical block is of the "skip type", the logical block of the integer vector may be skipped (operation 1348) and the method may proceed with operation 1344; otherwise, the corresponding logical block of the integer vector is searched (operation 1340) and the method may proceed with operation 1344.

A test may be performed to determine if all elements of the block encoding vector 322 have been selected (operation 1344). If all of the elements of the block encoding vector 322 have been selected, the method may end; otherwise, the method may proceed with operation 1336.

**FIGS. 14A-14C** illustrate a flowchart for an example method 1400 for executing a wildcard string-matching query of a split dictionary, in accordance with an example embodiment. In one example embodiment, one or more of the operations of the example method 1400 may be performed by the query execution module 622.

In one example embodiment, a Count (*) may be selected from the table "Table_Name" where Column_Name equals the query term 'Parameter' (operation 1404). The major dictionary and minor dictionary may be searched for '%Parameter%' and an array of integer values (integer identifiers) representing an offset information (index position) of each matched string relative to the start address of the searched split dictionary may be created (operation 1408). A test may be performed to determine if the matched strings belong to only one of the major dictionary and minor dictionary (operation 1412). If the matched strings belong to only one of the major dictionary and minor dictionary, the method may proceed with operation 1416; otherwise, the method may proceed with operation 1428.

During operation 1416, the dictionary to which the matched string(s) belong may be selected. In one example embodiment, the start address of the corresponding dictionary may be obtained (operation 1420). For example, a database manager may access a master metadata structure for "Table-Name" to retrieve the start address.

An element in the block encoding vector 322 may be selected (operation 1424) and the selected element may be tested to identify whether the selected element corresponds to the selected dictionary indicating that the corresponding logical block of the integer vector should be searched (operation 1440). If the selected element does not correspond to the selected dictionary, said logical block may be skipped (operation 1452) and the method may proceed with operation 1448; otherwise, the corresponding logical block, also referred herein as 'cluster', may be searched (operation 1444) and the method may proceed with operation 1448.

A test may be performed to determine if all elements of the block encoding vector 322 have been selected (operation 1448). If all of the elements of the block encoding vector 322 have been selected, the method may end; otherwise, the method may proceed with operation 1440. During operation 1428, both the major dictionary 314 and the minor dictionary 310 may be selected as the search space. In one example embodiment, the start address(es) of both the major dictionary 314 and the minor dictionary 310 may be obtained (operation 1432). For example, a database manager may access a master metadata structure for "Table_Name" to retrieve the start address(es).

An element in the block encoding vector 322 may be selected (operation 1436) and the selected element may be tested to identify whether the selected element corresponds to the selected dictionary indicating that the corresponding logical block of the integer vector should be searched (i.e., is not of the "skip type" - operation 1456). If the selected element does not correspond to the selected dictionary, the logical block may be skipped (operation 1468) and the method may proceed with operation 1464; otherwise, the corresponding logical block of the integer vector may be searched (operation 1460) and the method may proceed with operation 1464.

A test may be performed to determine if all elements of the block encoding vector 322 have been selected and evaluated for being of the skip-type (operation 1464). If all of the elements of the block encoding vector 322 have been selected, the method may end; otherwise, the method may proceed with operation 1456.

Space Optimization

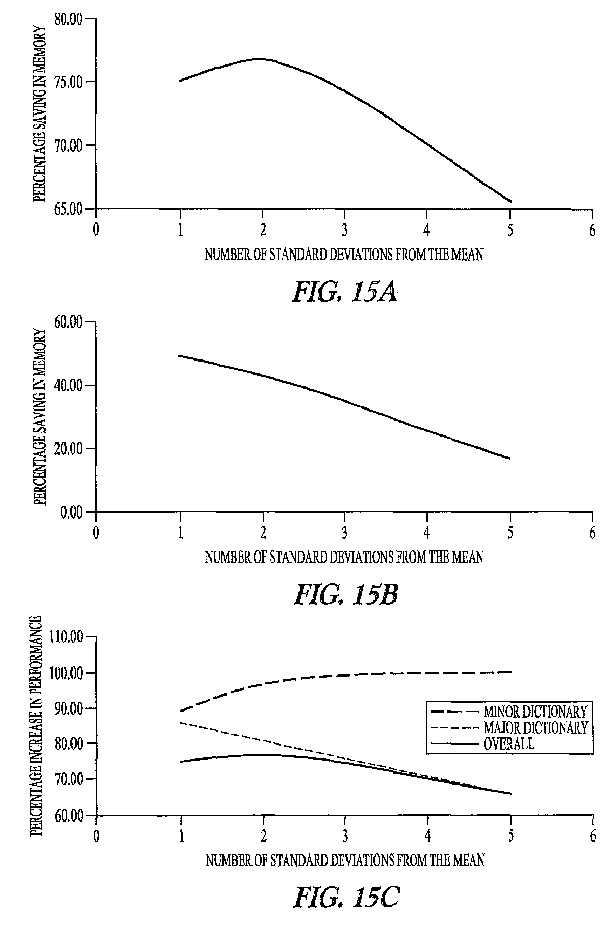

The split dictionary approach may provide a high compression ratio due to reduced column width in the major dictionary 314. **FIG. 15A** shows how a percentage savings in memory may vary with the choice of the number of standard deviations considered for the city dataset of **FIG. 3A**. In the city dataset, memory savings in the range of 65% to 76% may be achieved, while varying the spread from (mean + 1 sigma) (i.e., 15 bytes/characters) to (mean + 5 sigma) (i.e., 32 bytes/characters). **FIG. 15B** shows how a percentage savings in memory may vary with the choice of the number of standard deviations considered for the names dataset. The names dataset may result in memory savings of almost 50% for the varying ranges, as illustrated in **FIG. 15B.** The differences in the observations of the two datasets may be attributed to the varying difference between the longest record length and the mean of lengths in the dictionary, which is approximately 80 (91-11) characters for the cities dataset, and approximately 10 (34-14) characters for the names dataset.

Time/Performance Optimization: Reverse Lookup Efficiency

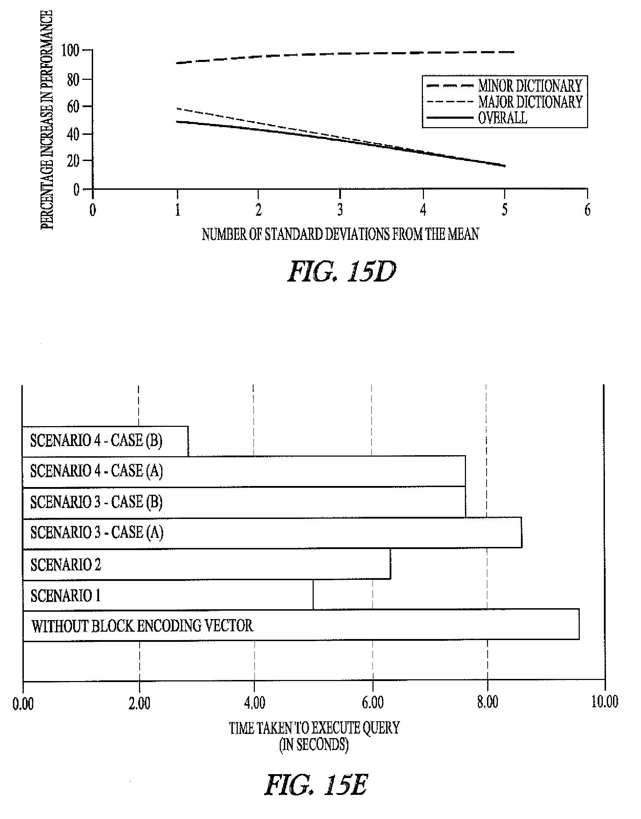

Reverse lookup efficiency is the speed with which the database can find the corresponding integer identifier of a unique string in the dictionary. In the split dictionary approach, the database manager has pre-defined information about the column width of each of the dictionaries. As a result, searching a particular string may be easier, as only the appropriate dictionary (on the basis of query parameter length) needs to be searched. In the particular case of searching only the minor dictionary table, the response rate increases substantially (nearly 100%) as the search space is limited to only a few records. **FIG. 15C** shows how a percentage increase in performance may vary with the choice of the number of standard deviations considered for the city dataset. The split dictionary approach can improve the performance of a search query by 76%, as compared to the conventional approach of using a single dictionary. **FIG. 15D** shows how a percentage increase in performance may vary with the choice of the number of standard deviations considered for the names dataset. Even in the case of the names dataset, the search queries can perform better by up to, for example, 50%.

As a greater number of strings are shifted from the minor dictionary 310 to the major dictionary 314, the performance of the major dictionary 314 starts deteriorating, whereas the performance of the minor dictionary 310 nearly reaches 100%. This happens as the number of strings in the minor dictionary 310 falls below 0.1 % of the total dictionary strings, resulting in a fast lookup.

Direct Access Advantage

An important factor to achieve high performance levels may be the ability to have direct dictionary access. Both the dictionaries 310, 314 in the split dictionary approach are of fixed length and thereby maintain direct access.

integer Vector Scanning Efficiency

In embodiments making use of integer encoding, database queries may be performed on the integer values rather than on the string values. At first, a string-based dictionary search may be performed for identifying an index position of a string in a split dictionary matching the search string. Then, the identified index position, optionally supplemented with an extra bit being indicative of the split dictionary that was searched, is used as an integer search term for searching the integer vector, e.g. for identifying the total number of occurrences of the integer value (and thus, the matching string) in the transactional integer vector. Therefore, another aspect to consider while analyzing performance gain in the split dictionary approach is that of scanning the integer vector values. In the block encoding vector 322 technique, there may be a definite improvement in the scan speeds. The percentage improvement, however, may vary substantially as the number of different types of blocks (minor, major, or mixed) varies.

An improvement of 70% for the scenario #4 may be attained, but only improvements in the range of 10-20% for the rest of the scenarios discussed above. **FIG. 15E** shows a comparison of the time needed to execute a search query in the different scenarios versus the case of not employing the block encoding vector 322 technique.

Improved Cache Utilization

The DRAM and cache capacity of conventional systems are limited. The reduction in storage requirements means the number of new cache loads may decrease, and the cache hit rate may improve. This may result in faster searching of strings in the column stores.

Faster Backup & Recovery

In-Memory database systems may have a backup mechanism to maintain high availability and fault tolerance. The in-memory database system may be, for example, the SAP HANA DBMS. The snapshot functions provided by the HANA DBMS or by another type of in-memory may be used for performing delta updates of the split dictionaries. When performing said snapshot functions, the data is backed up to an SSD (Solid State Drive) or an HDD (Hard Disk Drive) at regular intervals and only the log entries are replayed during recovery. With the reduced memory space of a dictionary, the time taken to perform the 1/0 (Input/Output) from in-memory systems may be faster for saving the information and the recovery process. While storing the dictionary and attribute values, the database may also backup the dictionary's metadata which may help with memory allocation needed while in recovery mode. Reduced memory usage may therefore lead to faster backups and/or recovery of data.

Easier Reconstruction of a Tuple

Unlike compression techniques like run-length encoding, cluster encoding, and the like, a split dictionary approach may not impact the usability and the data organization of the integer vector. Fixed sizes of memory or storage reserved for each integer value of the integer vector (corresponding e.g. to fixed column widths) of integer vectors may be maintained (same as single dictionary approach combined with the integer vector). In the split dictionary approach, the integer identifiers may be mapped directly to the major or minor dictionary 314, 310. This may ensure a faster response during join operations over multiple columns and tables for accessing the particular row (with row-id) and for fetching a unique string from the dictionary.

Improved Updates of Dictionary and Attribute Vector

The split dictionary approach may improve dictionary updates since the updates only impact one of the dictionaries 310, 314 and the relocation of strings (below the new entry) only needs to be done for one of the dictionaries 310, 314. Particularly in the case of updating the minor dictionary 310, there are significant improvements as the number of records in the minor dictionary 310 may be less than 1% of the total. The updating of the integer values in the integer vector being identical to the index positions of their respective string values in the source split index may also be improved, depending upon the implementation of the integer vector mapping to the split dictionaries (as described above).

Advantages in Multi-core Parallel Processing

For parallel processing, the integer vector may be partitioned based on a fixed number of records and all the nodes may be run in parallel, for every query. With the usage of block encoding vector 322, there may be a possibility of wisely partitioning the integer vector, such that a certain percentage of partitions are mapped to a particular dictionary only. The query may not be executed on all of the nodes, as the query term may map to only one of the dictionaries.

This may help in running the query on dictionary specific nodes only, resulting in data locality as well as query load optimization.

Multi-column Optimization

According to embodiments, the dictionary is implemented as a single column of a multi-dictionary database table. Said multi-dictionary table comprises one or more further columns, each of the one or more further columns constituting a respective dictionary for a different property. For example, there could exist a "two-dictionary table" whose first column constitutes a dictionary of unique city names and whose second column constitutes a dictionary of unique identifiers of the respective cities. Alternatively, the content of the second column may semantically be unrelated to the content of the first column of the multi-dictionary table. For each column in the multi-dictionary database table, according to embodiments, two or more respective split dictionaries may be created. For each of said columns in a multi-dictionary database table, according to embodiments, two or more respective integer encoding vectors may be created. However, according to embodiments, only a single integer vector is generated for all the columns (i.e., dictionaries) of the multi-dictionary database table. The integer vector is created by an integer encoding function which uses the index position of the records in a dictionary as the integer output generated for said dictionary record. This can help multiple columns/dictionaries to leverage this advantage in parallel, without having to change the index position, because all column values of the multi-dictionary table of the same record (table row) share the same dictionary index position. Also, CPU and/or memory and/or storage consumption may be reduced because the integer vector is created only once for multiple dictionaries. This may result in optimized AV scanning, an advantage that may not be possible with known existing techniques like prefix encoding, run length coding, cluster coding and sparse coding. Such compression techniques have a good compression ratio, but the overall performance may be impacted severely due to loss of row identifiers. Also, the key to achieving a high compression ratio may be dependent on the distribution of data and the best compression may be leveraged by sorting the complete AV and then applying one of the conventional compression techniques. Indirect coding algorithms try to address the row identifiers while encoding the values of each block with local dictionary. All these approaches work on a single column of the table and generally after applying the heuristic of compression across columns, one can choose the best fit column for applying these approaches individually or together. In this case, after sorting a single column of the table, the same cannot be applied to other columns, since there is no way of preserving the row identifiers across multiple compressed columns. Therefore, queries across multiple columns may not perform well. However, with the BEV approach, multiple (or all) columns of a multi-dictionary database table can be optimized simultaneously, thus resulting in an overall improved performance.

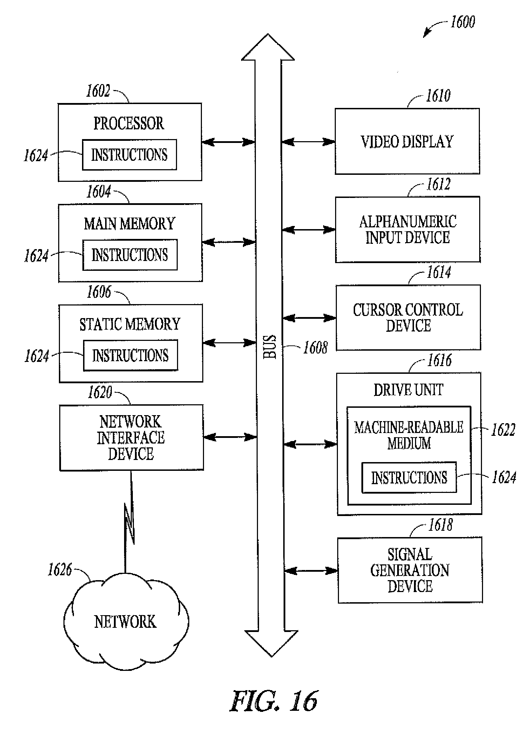

FIG. 16 is a block diagram of a computer processing system within which a set of instructions, for causing the computer to perform any one or more of the methodologies discussed herein, may be executed. In some embodiments, the computer operates as a standalone device or may be connected (e.g., networked) to other computers. In a networked deployment, the computer may operate in the capacity of a server or a client computer in server-client network environment, or as a peer computer in a peer-to-peer (or distributed) network environment.

In addition to being sold or licensed via traditional channels, embodiments may also, for example, be deployed by software-as-a-service (SaaS), application service provider (ASP), or by utility computing providers. The computer may be a server computer, a personal computer (PC), a tablet PC, a set-top box (STB), a personal digital assistant (PDA), cellular telephone, or any processing device capable of executing a set of instructions (sequential or otherwise) that specify actions to be taken by that device. Further, while only a single computer is illustrated, the term "computer" shall also be taken to include any collection of computers that, individually or jointly, execute a set (or multiple sets) of instructions to perform any one or more of the methodologies discussed herein.

The example computer processing system 1600 includes a processor 1602 (e.g., a central processing unit (CPU), a graphics processing unit (GPU) or both), a main memory 1604 and static memory 1606, which communicate with each other via a bus 1608. The computer processing system 1600 may further include a video display unit 1610 (e.g., a plasma display, a liquid crystal display (LCD) or a cathode ray tube (CRT)). The computer processing system 1600 also includes an alphanumeric input device 1612 (e.g., a keyboard), a user interface (UI) navigation device 1614 (e.g., a mouse, touch screen, or the like), a drive unit 1616, a signal generation device 1618 (e.g., a speaker), and a network interface device 1620.

The drive unit 1616 includes machine-readable medium 1622 on which is stored one or more sets of instructions 1624 and data structures embodying or utilized by any one or more of the methodologies or functions described herein. The instructions 1624 may also reside, completely or at least partially, within the main memory 1604, static memory 1606, and/or within the processor 1602 during execution thereof by the computer processing system 1600, the main memory 1604, static memory 1606, and the processor 1602 also constituting machine-readable, tangible media.

The instructions 1624 may further be transmitted or received over network 1626 via a network interface device 1620 utilizing any one of a number of well-known transfer protocols (e.g., Hypertext Transfer Protocol).

While the machine-readable medium 922 is shown in an example embodiment to be a single medium, the term " machine -readable medium" should be taken to include a single medium or multiple media (e.g., a centralized or distributed database, and/or associated caches and servers) that store the one or more sets of instructions 1624. The term " machine -readable medium" shall also be taken to include any medium that is capable of storing, encoding or carrying a set of instructions 1624 for execution by the computer and that cause the computer to perform any one or more of the methodologies of the present application, or that is capable of storing, encoding or carrying data structures utilized by or associated with such a set of instructions 1624. The term "machine -readable medium" shall accordingly be taken to include, but not be limited to, solid-state memories, and optical and magnetic media.

While the invention(s) is (are) described with reference to various implementations and exploitations, it will be understood that these embodiments are illustrative and that the scope of the invention(s) is not limited to them. In general, techniques for maintaining consistency between data structures may be implemented with facilities consistent with any hardware system or hardware systems defined herein. Many variations, modifications, additions, and improvements are possible.

Plural instances may be provided for components, operations or structures described herein as a single instance. Finally, boundaries between various components, operations, and data stores are somewhat arbitrary, and particular operations are illustrated in the context of specific illustrative configurations. Other allocations of functionality are envisioned and may fall within the scope of the invention(s). In general, structures and functionality presented as separate components in the exemplary configurations may be implemented as a combined structure or component. Similarly, structures and functionality presented as a single component may be implemented as separate components. These and other variations, modifications, additions, and improvements fall within the scope of the invention(s).

## Claims

1. A computer-implemented data compression method comprising:

   - providing a dictionary (300) comprising a plurality of data records, each of said data records being stored in a memory element whose size is sufficiently large to store the longest one of the data records of the dictionary; the method **characterised by**:

       - computing a mean of the lengths of the data records of the dictionary;
       - computing a standard deviation of the lengths of the data records of the dictionary;
       - determining a deviation threshold, the deviation threshold indicating a maximum allowable deviation of a data record length from a mean data record length;
       - calculating a threshold data record length from the computed mean, from the computed standard deviation and from the determined deviation threshold;
       - splitting the dictionary into a minor dictionary (314) and a major dictionary (310), the major dictionary selectively comprising the ones of the data records whose lengths are below or equal to the calculated threshold data record length, the minor dictionary selectively comprising the ones of the data records whose lengths are larger than the calculated threshold data record length;
       - storing the data records of the major dictionary in a first array of further memory elements, whereby the size of each further memory element is fitted to the memory space consumed by a data record of the calculated threshold data record length; and
       - storing the data records of the minor dictionary in a second array of still further memory elements, whereby the size of each still further memory element is fitted to the memory space consumed by the longest one of all data records of the dictionary.

2. The computerized method of claim 1, wherein the determining of the deviation threshold comprises:

   - determining a plurality of different candidate deviation thresholds;
   - calculating, for each of said candidate deviation thresholds, a candidate threshold data record length from the computed mean, from the computed standard deviation and from the determined candidate deviation threshold;
   - determining, for each of said candidate deviation thresholds, the number of data records that would be stored in a candidate major dictionary and in a candidate minor dictionary in case of using said candidate deviation threshold for splitting the dictionary into the candidate minor dictionary and the candidate major dictionary, and calculating a total size of a combination of said candidate major dictionary and the candidate minor dictionary;
   - ranking the candidate deviation thresholds, whereby the larger said total size of the candidate major and minor dictionary calculated for said candidate deviation threshold, the lower the rank; and
   - selecting the one of the candidate deviation thresholds having assigned the highest rank as the determined deviation threshold.

3. The computer-implemented method of any one of the previous claims, further comprising:

- obtaining a length of a query term;
- determining if the obtained length is larger than the calculated threshold data record length;
- if the obtained length is larger than the calculated threshold data record length, selectively searching the query term in the minor dictionary;
- if the obtained length is smaller or equal to the calculated threshold data record length, selectively searching the query term in the major dictionary.

4. The computer-implemented method of any one of the previous claims, wherein all of the data records of the dictionary (300) are unique, the method further comprising:

- generating the dictionary as a derivative of an original vector of data records, the original vector of data records comprising at least two identical copies of the same data record;
- generating a mapping, the mapping linking each unique data record in the dictionary to one or more identical data records in the original vector.

5. The computer-implemented method of any one of the previous claims, further comprising:

- determining at least a further deviation threshold, the further deviation threshold being smaller than the deviation threshold;
- calculating, for the further deviation threshold, a further threshed data record length from the computed mean, from the computed standard deviation and from the further deviation threshold; and
- wherein the splitting of the dictionary comprises splitting the dictionary into the minor dictionary, the major dictionary and the further major dictionary,

    o the minor dictionary selectively comprising the ones of the data records whose lengths are larger than the calculated threshold data record length and smaller than or equal to the maximum data record length of all data records of the dictionary,
    o the further major dictionary selectively comprising the ones of the data records whose lengths are larger than the further calculated threshold data record length and whose lengths are below or equal to the calculated threshold data record length;.
    o the major dictionary selectively comprising the ones of the data records whose lengths are below or equal to the calculated further threshold data record length.

6. The computer-implemented method of any one of the previous claims, further comprising:

- storing the data records of the major dictionary in a first contiguous memory space and/or in a first contiguous non-volatile storage space; and/or
- storing the data records of the minor dictionary in a second contiguous memory space and/or in a second contiguous non-volatile storage space.

7. The computer-implemented method of any one of the previous claims, further comprising:

- flagging each data record of the dictionary with a split dictionary-ID, the split-dictionary-ID being indicative of the minor dictionary in case said data record was stored in the minor dictionary, the split-dictionary-ID being indicative of the major dictionary in case said data record was stored in the major dictionary, each flag consisting of one or more bits; and/or
- flagging each data record contained in an original vector with a split diction-ary-ID, the dictionary merely comprising unique data records, the original vector being a version of the dictionary which comprises multiple identical data records, the split-dictionary-ID being indicative of the minor dictionary in case said data record of the original vector was stored in the minor dictionary, the split-dictionary-ID being indicative of the major dictionary in case said data record of the original vector was stored in the major dictionary, each flag consisting of one or more bits; and/or
- adding to each integer value contained in an integer vector (318) at least one extra bit, the at least one extra-bit acting as an identifier for the minor dictionary or for the major dictionary, the dictionary merely comprising unique data records which have been extracted from all string values contained in an original vector, the original vector comprising multiple identical data record instances, each integer value in the integer vector having been generated by applying an integer encoding function on a string value contained in the minor or major dictionary, the at least one extra bit added to one of the integer values being indicative of the minor dictionary in case said integer value was generated by the integer encoding function using a data record in the minor dictionary as input, the at least one extra bit being indicative of the major dictionary in case said integer value was generated by the integer encoding function using a data record in the major dictionary as input.

8. The computer-implemented method of any one of the previous claims, further comprising:

 - providing a sequence of strings, the sequence of strings comprising a plurality of different string values and at least two identical string values;
 - generating the dictionary as a derivative of the sequence of strings, the dictionary consisting of the unique string values of the sequence of strings, each unique string value being one of the data records of the dictionary;
 - creating an integer vector (318) from the sequence of strings by:

   ◦ applying an integer encoding function on each string of the dictionary, the integer encoding function being a function that generates, for each unique string value of the dictionary, a respective unique integer value; and
   ◦ by storing said unique integer value in one or more elements of the integer vector.

9. The computer-implemented method of claim 8, further comprising:

 - receiving a query comprising a query term;
 - applying the integer encoding function on the query term, thereby creating a query integer value;
 - performing a search of the query integer value on the integer vector;
 - identifying one or more matching integer values in the integer vector, each matching integer value matching the query integer value; and
 - returning the number of the identified one or more matching string values.

10. The computer-implemented method of claim 8 or 9, the method further comprising:

 - determining a block size number, the block size number being an integer;
 - Logically splitting the integer vector after each continuous sequence of determined block size number of integer values, thereby creating a plurality of logical blocks of the integer vector;
 - generating a block encoding vector (322), the block encoding vector comprising one encoding element for each of said logical blocks, each encoding element having assigned a respective one of the logical blocks;
 - for each of the created logical blocks, determining a block type, the block type being one of:

   ◦ a major block, wherein all integer values contained in a major block were created from one of the string values being stored in the major dictionary; or
   ◦ a minor block, wherein all integer values contained in a minor block were created from one of the string values being stored in the minor dictionary; or
   ◦ a mixed block, wherein at least a first one of the integer values contained in a mixed block was created from one of the string values being stored in the minor dictionary and wherein at least a second one of the integer values contained in said mixed block was created from one of the string values being stored in the major dictionary;

 - for each of the created logical blocks, storing the determined block-type-ID of said logical block into the one of the encoding elements assigned to said logical block;
 - obtaining the length of the query term for determining if said obtained length is larger than the calculated threshold data record length;
 - if the obtained length is larger than the calculated threshold data record length, selecting the major block type as a skip-type;
 - if the obtained length is smaller or equal to the calculated threshold data record length, selecting the minor block type as a skip-type;
 - performing a search of the query integer value on the integer vector, thereby skipping all integer values being contained in a logical block of the skip-type.

**11.** The computer-implemented method of claim 10,

- wherein the block types in the block encoding vector are specified in the form of a predefined number of bits,
- wherein the block type selected as the skip type is specified by the predefined number of bits;
- wherein the skipping of the integer values contained in a logical block of the skip-type comprises evaluating the selected skip type on the block types by means of linear search within the block encoding vector.

**12.** The computer-implemented method of claim 10 or 11, wherein the determining of the block size number comprises:

- determining a plurality of candidate block size numbers;
- for each of the candidate block size numbers: logically splitting the integer vector for creating a plurality of logical blocks comprising said candidate block size number of integer values, generating a respective block encoding vector and determining a block type for each of said created logical blocks of said block encoding vector;
- for each of the candidate block size numbers, computing a performance cost, wherein the performance cost is calculated as: BEV_Performance_Cost =(Total_Major_Dictionary_Blocks+Total_Mixed_Dictionary_Blocks)*Major_Di ctionary_Count + (Total_Minor_Dictionary_Blocks+Total_Mixed_Dictionary_Blocks)*Minor_Dictionary_Count, or as a derivative of said BEV_Performance_Cost value,

  ◦ wherein BEV_Performance_Cost is the performance cost;
  ◦ wherein Total_Major_Dictionary_Blocks is the total number of logical blocks of major block type that is obtained when using said candidate block size number for the logical splitting;
  ◦ wherein Total_Mixed_Dictionary_Blocks is the total number of logical blocks of mixed block type that is obtained when using said candidate block size number for the logical splitting;
  ◦ wherein Total_Minor_Dictionary_Blocks is the total number of logical blocks of minor block type that is obtained when using said candidate block size number for the logical splitting;
  ◦ wherein Major_Dictionary_Count is the total number of data records of the major dictionary that is obtained when using said candidate block size number for the logical splitting;
  ◦ wherein Minor_Dictionary_Count is the total number of data records of the minor dictionary that is obtained when using said candidate block size number for the logical splitting;

- ranking the computed performance costs, wherein the lower the performance costs, the higher the rank; and
- using the candidate block size number whose computed performance costs have the highest rank as the determined block size number.

**13.** The computer-implemented method of any one of claims 10-12,

- wherein the determining of the block size number is executed for each of a plurality of candidate deviation thresholds, whereby for each candidate deviation threshold, a total size according to claim 2 is calculated; and
- wherein for each of the candidate deviation thresholds, performance costs are calculated for each of a plurality of candidate block size numbers, wherein the performance costs are calculated preferentially according to claim 12, thereby calculating a combined cost score for each evaluated pair of candidate block size number and candidate deviation threshold;
- whereby the higher the computed performance costs calculated for a particular candidate block size number, the higher the combined cost score;
- whereby the larger said total size of the candidate major and minor dictionary calculated for a candidate deviation threshold, the higher the combined cost score; and
- wherein the method further comprises selecting the pair of candidate deviation threshold and candidate block size number corresponding to the lowest combined cost score.

**14.** A non-transitory storage medium comprising computer-interpretable instructions, whereby the instructions, when executed by a processor, cause the processor to execute a method according to any one of the previous claims.

**15.** A computer system (602) comprising a processor and a main memory, the processor being configured for:

- providing a dictionary (300) comprising a plurality of data records, each of said data records being stored in a memory element of the main memory, whereby the size of each of said memory elements is sufficiently large to store the longest one of the data records of the dictionary; and the system being **characterised by**

- computing a mean and a standard deviation of the lengths of the data records of the dictionary;
- determining a deviation threshold, the deviation threshold indicating a maximum allowable deviation of a data record length from a mean data record length, the unit of the deviation threshold being standard deviations;
- calculating a threshold data record length from the computed mean, the computed standard deviation and from the determined deviation threshold;
- splitting the dictionary into a minor dictionary (314) and a major dictionary (310), the major dictionary selectively comprising the ones of the data records whose lengths are below or equal to the calculated threshold data record length, the minor dictionary selectively comprising the ones of the data records whose lengths are larger than the calculated threshold data record length;
- storing the data records of the major dictionary in a first array of further memory elements, whereby the size of each further memory element is fitted to the memory space consumed by a data record of the calculated threshold data record length; and
- storing the data records of the minor dictionary in a second array of still further memory elements, whereby the size of each of the still further memory element is fitted to the memory space consumed by the longest one of all data records of the dictionary.

**Patentansprüche**

1. Computerimplementiertes Datenkompressionsverfahren, das Folgendes aufweist:

- Bereitstellen eines Wörterbuchs (300), das mehrere Datensätze aufweist, wobei jeder der genannten Datensätze in einem Speicherelement gespeichert wird, dessen Größe groß genug ist, um den längsten der Datensätze des Wörterbuchs zu speichern;

wobei das Verfahren **gekennzeichnet ist durch**:

- Berechnen eines Mittels der Längen der Datensätze des Wörterbuchs;
- Berechnen einer Standardabweichung der Längen der Datensätze des Wörterbuchs;
- Ermitteln eines Abweichungsschwellenwerts, wobei der Abweichungsschwellenwert eine maximale zulässige Abweichung einer Datensatzlänge von einer mittleren Datensatzlänge angibt;
- Ausarbeiten einer Schwellenwertdatensatzlänge anhand des berechneten Mittels, anhand der berechneten Standardabweichung und anhand des ermittelten Abweichungsschwellenwerts;
- Aufteilen des Wörterbuchs in ein Nebenwörterbuch (314) und ein Hauptwörterbuch (310), wobei das Hauptwörterbuch selektiv diejenigen der Datensätze aufweist, deren Länge so groß wie die ausgearbeitete Schwellenwertdatensatzlänge oder darunter ist, wobei das Nebenwörterbuch selektiv diejenigen der Datensätze aufweist, deren Länge größer als die ausgearbeitete Schwellenwertdatensatzlänge ist;
- Speichern der Datensätze des Hauptwörterbuchs in einem ersten Array weiterer Speicherelemente, so dass sich die Größe jedes weiteren Speicherelements nach dem von einem Datensatz der ausgearbeiteten Schwellenwertdatensatzlänge verbrauchten Speicherplatz richtet; und
- Speichern der Datensätze des Nebenwörterbuchs in einem zweiten Array noch weiterer Speicherelemente, so dass die Größe jedes noch weiteren Speicherelements sich nach dem von dem längsten aller Datensätze des Wörterbuchs verbrauchten Speicherplatz richtet.

2. Computerisiertes Verfahren nach Anspruch 1, wobei das Ermitteln des Abweichungsschwellenwerts Folgendes aufweist:

- Ermitteln mehrerer verschiedener Abweichungsschwellenwertkandidaten;
- Ausarbeiten eines Schwellenwertdatensatzlängenkandidaten für jeden der genannten Abweichungsschwellenwertkandidaten anhand des berechneten Mittels, anhand der berechneten Standardabweichung und anhand des ermittelten Abweichungsschwellenwertkandidaten;
- Ermitteln der Zahl von Datensätzen, die im Fall der Verwendung des genannten Abweichungsschwellenwertkandidaten zum Aufteilen des Wörterbuchs in den Nebenwörterbuchkandidaten und den Hauptwörterbuchkandidaten in einem Hauptwörterbuchkandidaten und in einem Nebenwörterbuchkandidaten gespeichert würden, für jeden der genannten Abweichungsschwellenwertkandidaten und Ausarbeiten einer Gesamtgröße einer Kombination des genannten Hauptwörterbuchkandidaten und Nebenwörterbuchkandidaten;
- Einstufen der Abweichungsschwellenwertkandidaten, so dass die Einstufung um so niedriger ist, je größer die genannte Gesamtgröße des Hauptkandidaten und des Nebenkandidaten ist, die für den genannten Abweichungsschwellenwertkandidaten ausgearbeitet wird; und
- Auswählen des einen der Abweichungsschwellenwertkandidaten, dem die höchste Einstufung zugewiesen wurde, als den ermittelten Abweichungsschwellenwert.

**3.** Computerimplementiertes Verfahren nach einem der vorhergehenden Ansprüche, das ferner Folgendes aufweist:

- Beschaffen einer Länge eines Abfragebegriffs;
- Ermitteln, ob die beschaffte Länge größer als die ausgearbeitete Schwellenwertdatensatzlänge ist;
- wenn die beschaffte Länge größer als die ausgearbeitete Schwellenwertdatensatzlänge ist, selektives Suchen nach dem Abfragebegriff im Nebenwörterbuch;
- wenn die beschaffte Länge so groß wie die ausgearbeitete Schwellenwertdatensatzlänge oder kleiner ist, selektives Suchen nach dem Abfragebegriff im Hauptwörterbuch.

**4.** Computerimplementiertes Verfahren nach einem der vorhergehenden Ansprüche, wobei alle Datensätze des Wörterbuchs (300) eindeutig sind, wobei das Verfahren ferner Folgendes aufweist:

- Generieren des Wörterbuchs als Ableitung eines Ursprungsvektors von Datensätzen, wobei der Ursprungsvektor von Datensätzen wenigstens zwei identische Kopien desselben Datensatzes aufweist;
- Generieren eines Mapping, wobei das Mapping jeden eindeutigen Datensatz in dem Wörterbuch mit einem oder mehr identischen Datensätzen in dem Ursprungsvektor verknüpft.

**5.** Computerimplementiertes Verfahren nach einem der vorhergehenden Ansprüche, das ferner Folgendes aufweist:

- Ermitteln wenigstens eines weiteren Abweichungsschwellenwerts, wobei der weitere Abweichungsschwellenwert kleiner als der Abweichungsschwellenwert ist;
- Ausarbeiten einer weiteren Schwellenwert-Datensatzlänge anhand des berechneten Mittels, anhand der berechneten Standardabweichung und anhand des weiteren Abweichungsschwellenwerts für den weiteren Abweichungsschwellenwert; und
- wobei das Aufteilen des Wörterbuchs das Aufteilen des Wörterbuchs in das Nebenwörterbuch, das Hauptwörterbuch und das weitere Hauptwörterbuch aufweist,

  ∘ wobei das Nebenwörterbuch selektiv diejenigen der Datensätze aufweist, deren Länge größer als die ausgearbeitete Schwellenwertdatensatzlänge und so groß wie die maximale Datensatzlänge aller Datensätze des Wörterbuchs oder kleiner ist;
  ∘ wobei das weitere Hauptwörterbuch selektiv diejenigen der Datensätze aufweist, deren Länge größer als die weitere ausgearbeitete Schwellenwertdatensatzlänge ist und deren Länge so groß wie die ausgearbeitete Schwellenwertdatensatzlänge oder darunter ist;
  ∘ wobei das Hauptwörterbuch selektiv diejenigen der Datensätze aufweist, deren Länge so groß wie die ausgearbeitete weitere Schwellenwertdatensatzlänge oder darunter ist.

**6.** Computerimplementiertes Verfahren nach einem der vorhergehenden Ansprüche, das ferner Folgendes aufweist:

- Speichern der Datensätze des Hauptwörterbuchs in einem ersten zusammenhängenden Speicherplatz und/oder in einem ersten zusammenhängenden nichtflüchtigen Speicherplatz und/oder
- Speichern der Datensätze des Nebenwörterbuchs in einem zweiten zusammenhängenden Speicherplatz und/oder in einem zweiten zusammenhängenden nichtflüchtigen Speicherplatz.

**7.** Computerimplementiertes Verfahren nach einem der vorhergehenden Ansprüche, das ferner Folgendes aufweist:

- Markieren jedes Datensatzes des Wörterbuchs mit einer Kennung des geteilten Wörterbuchs, wobei die Kennung des geteilten Wörterbuchs in einem Fall, in dem der genannte Datensatz in dem Nebenwörterbuch gespeichert wurde, auf das Nebenwörterbuch hinweist, wobei die Kennung des geteilten Wörterbuchs in dem Fall, in dem der genannte Datensatz in dem Hauptwörterbuch gespeichert wurde, auf das Hauptwörterbuch hinweist, wobei jede Markierung aus einem oder mehr Bits besteht; und/oder
- Markieren jedes in einem Ursprungsvektor enthaltenen Datensatzes mit einer Kennung des geteilten Wörterbuchs, wobei das Wörterbuch lediglich eindeutige Datensätze aufweist, wobei der Ursprungsvektor eine Version des Wörterbuchs ist, die mehrere identische Datensätze aufweist, wobei die Kennung des geteilten Wörterbuchs in dem Fall, dass der genannte Datensatz des Ursprungsvektors in dem Nebenwörterbuch gespeichert wurde, auf das Nebenwörterbuch hinweist, wobei die Kennung des geteilten Wörterbuchs in dem Fall, dass der genannte Datensatz des Ursprungsvektors in dem Hauptwörterbuch gespeichert wurde, auf das Hauptwörterbuch hinweist, wobei jede Markierung aus einem oder mehr Bits besteht; und/oder

- Hinzufügen von wenigstens einem zusätzlichen Bit zu jedem in einem ganzzahligen Vektor (318) enthaltenen Ganzzahlwert, wobei das wenigstens eine zusätzliche Bit als Identifikator für das Nebenwörterbuch oder für das Hauptwörterbuch wirkt, wobei das Wörterbuch lediglich eindeutige Datensätze aufweist, die aus allen in einem Ursprungsvektor enthaltenen Zeichenkettenwerten extrahiert wurden, wobei der Ursprungsvektor mehrere identische Datensatzinstanzen aufweist, wobei jeder Ganzzahlwert im ganzzahligen Vektor durch Anwenden einer Ganzahlcodierfunktion auf einen in dem Neben- oder Hauptwörterbuch enthaltenen Zeichenkettenwert generiert wurde, wobei das zu einem der Ganzzahlwerte hinzugefügte wenigstens eine zusätzliche Bit in dem Fall, dass der genannte ganzzahlige Wert unter Verwendung eines Datensatzes in dem Nebenwörterbuch als Eingabe von der Ganzzahlcodierfunktion generiert wurde, auf das Nebenwörterbuch hinweist, wobei das wenigstens eine zusätzliche Bit in dem Fall, dass der genannte ganzzahlige Wert unter Verwendung eines Datensatzes in dem Hauptwörterbuch als Eingabe von der Ganzzahlcodierfunktion generiert wurde, auf das Hauptwörterbuch hinweist.

8. Computerimplementiertes Verfahren nach einem der vorhergehenden Ansprüche, das ferner Folgendes aufweist:

- Bereitstellen einer Zeichenkettenfolge, wobei die Zeichenkettenfolge mehrere verschiedene Zeichenkettenwerte und wenigstens zwei identische Zeichenkettenwerte aufweist;
- Generieren des Wörterbuchs als eine Ableitung der Zeichenkettenfolge, wobei das Wörterbuch aus den eindeutigen Zeichenkettenwerten der Zeichenkettenfolge besteht, wobei jeder eindeutige Zeichenkettenwert einer der Datensätze des Wörterbuchs ist;
- Erstellen eines ganzzahligen Vektors (318) anhand der Zeichenkettenfolge durch:

  ◦ Anwenden einer Ganzzahlcodierfunktion auf jede Zeichenkette des Wörterbuchs, wobei die Ganzzahlcodierfunktion eine Funktion ist, die für jeden eindeutigen Zeichenkettenwert des Wörterbuchs einen jeweiligen eindeutigen Ganzzahlwert generiert; und
  ◦ Speichern des genannten eindeutigen Ganzzahlwerts in einem oder mehr Elementen des ganzzahligen Vektors.

9. Computerimplementiertes Verfahren nach Anspruch 8, das ferner Folgendes aufweist:

- Empfangen einer Anfrage, die einen Abfragebegriff aufweist;
- Anwenden der Ganzzahlcodierfunktion auf den Abfragebegriff, wodurch ein ganzzahliger Abfragewert generiert wird;
- Durchführen einer Suche des ganzzahligen Abfragewerts am ganzzahligen Vektor;
- Identifizieren von einem oder mehr übereinstimmenden Ganzzahlwerten im ganzzahligen Vektor, wobei jeder übereinstimmende Ganzzahlwert mit dem ganzzahligen Abfragewert übereinstimmt; und
- Liefern der Zahl des/der identifizierten einen oder mehr übereinstimmenden Zeichenkettenwerte.

10. Computerimplementiertes Verfahren nach Anspruch 8 oder 9, wobei das Verfahren ferner Folgendes aufweist:

- Ermitteln einer Blockgrößenzahl, wobei die Blockgrößenzahl eine Ganzzahl ist;
- logisches Aufteilen des ganzzahligen Vektors nach jeder kontinuierlichen Folge ermittelter Blockgrößenzahl von Ganzzahlwerten, wodurch mehrere logische Blöcke des ganzzahligen Vektors erstellt werden;
- Generieren eines Blockcodiervektors (322), wobei der Blockcodiervektor ein Codierelement für jeden der genannten logischen Blöcke aufweist, wobei jedem Codierelement ein jeweiliger der logischen Blöcke zugewiesen ist;
- Ermitteln eines Blocktyps für jeden der erstellten logischen Blöcke, wobei der Blocktyp einer der Folgenden ist:

  ◦ ein Hauptblock, wobei alle in einem Hauptblock enthaltenen Ganzzahlwerte anhand von einem der in dem Hauptwörterbuch gespeicherten Zeichenkettenwerte erstellt wurden; oder
  ◦ ein Nebenblock, wobei alle in einem Nebenblock enthaltenen Ganzzahlwerte anhand von einem der in dem Nebenwörterbuch gespeicherten Zeichenkettenwerte erstellt wurden; oder
  ◦ ein gemischter Block, wobei wenigstens ein erster der in einem gemischten Block enthaltenen Ganzzahlwerte anhand von einem der in dem Nebenwörterbuch gespeicherten Zeichenkettenwerte erstellt wurde und wobei wenigstens ein zweiter der in dem genannten gemischten Block enthaltenen Ganzzahlwerte anhand von einem der in dem Hauptwörterbuch gespeicherten Zeichenkettenwerte erstellt wurde;

- Speichern der ermittelten Blocktypkennung des genannten logischen Blocks für jeden der erstellten logischen Blöcke in das eine der Codierelemente, die dem genannten logischen Block zugewiesen sind;
- Beschaffen der Länge des Abfragebegriffs zum Ermitteln, ob die genannte beschaffte Länge größer als die ausgearbeitete Schwellenwertdatensatzlänge ist;
- Wählen des Hauptblocktyps als einen Überspringungstyp, wenn die beschaffte Länge größer als die ausgearbeitete Schwellenwertdatensatzlänge ist;
- Wählen des Nebenblocktyps als einen Überspringungstyp, wenn die beschaffte Länge so groß wie die ausgearbeitete Schwellenwertdatensatzlänge oder kleiner ist;
- Durchführen einer Suche nach dem Abfrageganzzahlwert an dem ganzzahligen Vektor, wodurch alle in einem logischen Block des Überspringungstyps enthaltenen Ganzzahlwerte übersprungen werden.

**11.** Computerimplementiertes Verfahren nach Anspruch 10:

- wobei die Blocktypen in dem Blockcodiervektor in der Form einer vordefinierten Bitzahl vorgegeben werden,
- wobei der als der Überspringungstyp gewählte Blocktyp von der vordefinierten Bitzahl vorgegeben wird;
- wobei das Überspringen der in einem logischen Block des Überspringungstyps enthaltenen Ganzzahlwerte das Auswerten des ausgewählten Überspringungstyps an den Blocktypen mittels linearer Suche innerhalb des Blockcodiervektors aufweist.

**12.** Computerimplementiertes Verfahren nach Anspruch 10 oder 11, wobei das Ermitteln der Blockgrößenzahl Folgendes aufweist:

- Ermitteln mehrerer Blockgrößenzahlkandidaten;
- für jeden der Blockgrößenzahlkandidaten: logisches Aufteilen des ganzzahligen Vektors zum Erstellen mehrerer logischer Blöcke, die den genannten Blockgrößenzahlkandidaten ganzzahliger Werte aufweisen, Generieren eines jeweiligen Blockcodiervektors und Ermitteln eines Blocktyps für jeden der genannten erstellten logischen Blöcke des genannten Blockcodiervektors;
- Berechnen eines Durchführungsaufwands für jeden der Blockgrößenzahlkandidaten, wobei der Durchführungsaufwand ausgearbeitet wird als: BEV_Performance_Cost = (Total_Major_Dictionary_Blocks+Total_Mixed_Dictionary_Blocks)*Major_D ictionary_Count+(Total_Minor_Dictionary_Blocks+Total_Mixed_Dictionary_ Blocks)*Minor_Dictionary_Count, oder als eine Ableitung des genannten BEV_Performance_Cost-Werts,

  ◦ wobei BEV_Performance_Cost der Durchführungsaufwand ist;
  ◦ wobei Total_Major_Dictionary_Blocks die Gesamtzahl logischer Blöcke des Hauptblocktyps ist, die beschafft wird, wenn der genannte Blockgrößenzahlkandidat für das logische Aufteilen verwendet wird;
  ◦ wobei Total_Mixed_Dictionary_Blocks die Gesamtzahl logischer Blöcke des gemischten Blocktyps ist, die beschafft wird, wenn der genannte Blockgrößenzahlkandidat für das logische Aufteilen verwendet wird;
  ◦ wobei Total_Minor_Dictionary_Blocks die Gesamtzahl logischer Blöcke des Nebenblocktyps ist, die beschafft wird, wenn der genannte Blockgrößenzahlkandidat für das logische Aufteilen verwendet wird;
  ◦ wobei Major_Dictionary_Count die Gesamtzahl von Datensätzen des Hauptwörterbuchs ist, die beschafft wird, wenn der genannte Blockgrößenzahlkandidat für das logische Aufteilen verwendet wird;
  ◦ wobei Minor_Dictionary_Count die Gesamtzahl der Datensätze des Nebenwörterbuchs ist, die beschafft wird, wenn der genannte Blockgrößenzahlkandidat für das logische Aufteilen verwendet wird;

- Einstufen des berechneten Durchführungsaufwands, wobei der Durchführungsaufwand umso niedriger ist, je höher die Einstufung ist; und
- Verwenden des Blockgrößenzahlkandidaten, dessen berechneter Durchführungsaufwand die höchste Einstufung hat, als die ermittelte Blockgrößenzahl.

**13.** Computerimplementiertes Verfahren nach einem der Ansprüche 10 bis 12,

- wobei das Ermitteln der Blockgrößenzahl für jeden von mehreren Abweichungsschwellenwertkandidaten ausgeführt wird, so dass für jeden Abweichungsschwellenwertkandidaten eine Gesamtgröße gemäß Anspruch 2 ausgearbeitet wird, und

- wobei für jeden der Abweichungsschwellenwertkandidaten der Durchführungsaufwand für jeden von mehreren Blockgrößenzahlkandidaten ausgearbeitete wird, wobei der Durchführungsaufwand vorzugsweise nach Anspruch 12 ausgearbeitete wird, wodurch eine kombinierte Aufwandsbewertung für jedes ausgewertete Paar von Blockgrößenzahlkandidat und Abweichungsschwellenwertkandidat ausgearbeitete wird;

- so dass die kombinierte Aufwandsbewertung umso höher ist, je höher der berechnete Kostenaufwand ist, der für einen speziellen Blockgrößenzahlkandidaten ausgearbeitet wurde;

- so dass die kombinierte Aufwandsbewertung umso höher ist, je größer die genannte Gesamtgröße des Haupt- und des Nebenwörterbuchkandidaten ist, die für einen Abschweichungsschwellenwert ausgearbeitete wurde; und

- wobei das Verfahren ferner das Auswählen des Paars von Abweichungsschwellenwertkandidat und Blockgrößenzahlkandidat aufweist, das der geringsten kombinierten Aufwandsbewertung entspricht.

14. Nichtflüchtiges Speichermedium, das computerinterpretierbare Anweisungen aufweist, bei dem die Anweisungen bei Ausführung durch einen Prozessor den Prozessor zum Ausführen eines Verfahrens nach einem der vorhergehenden Ansprüche veranlassen.

15. Computersystem (602), das einen Prozessor und einen Hauptspeicher aufweist, wobei der Prozessor konfiguriert ist zum:

- Bereitstellen eines Wörterbuchs (300), das mehrere Datensätze aufweist, wobei jeder der genannten Datensätze in einem Speicherelement des Hauptspeichers gespeichert wird, bei dem die Größe von jedem der genannten Speicherelemente groß genug ist, um den längsten der Datensätze des Wörterbuchs zu speichern;

und das System **gekennzeichnet ist durch**:

- Berechnen eines Mittels und einer Standardabweichung der Längen der Datensätze des Wörterbuchs;
- Ermitteln eines Abweichungsschwellenwerts, wobei der Abweichungsschwellenwert eine maximale zulässige Abweichung einer Datensatzlänge von einer mittleren Datensatzlänge angibt, wobei die Einheit des Abweichungsschwellenwerts Standardabweichungen sind;
- Ausarbeiten einer Schwellenwertdatensatzlänge anhand des berechneten Mittels, der berechneten Standardabweichung und anhand des ermittelten Abweichungsschwellenwerts;
- Aufteilen des Wörterbuchs in ein Nebenwörterbuch (314) und ein Hauptwörterbuch (310), wobei das Hauptwörterbuch selektiv diejenigen der Datensätze aufweist, deren Länge so groß wie die ausgearbeitete Schwellenwertdatensatzlänge oder darunter ist, wobei das Nebenwörterbuch selektiv diejenigen der Datensätze aufweist, deren Länge größer als die ausgearbeitete Schwellenwertdatensatzlänge ist;
- Speichern der Datensätze des Hauptwörterbuchs in einem ersten Array weiterer Speicherelemente, so dass sich die Größe jedes weiteren Speicherelements nach dem von einem Datensatz der ausgearbeiteten Schwellenwertdatensatzlänge verbrauchten Speicherplatz richtet; und
- Speichern der Datensätze des Nebenwörterbuchs in einem zweiten Array noch weitererer Speicherelemente, so dass die Größe jedes noch weiteren Speicherelements sich nach dem von dem längsten aller Datensätze des Wörterbuchs verbrauchten Speicherplatz richtet.

## Revendications

1. Procédé de compression de données mis en oeuvre par ordinateur comprenant :

- la mise à disposition d'un dictionnaire (300) comprenant une pluralité d'enregistrements de données, chacun desdits enregistrements de données étant stocké dans un élément de la mémoire dont la taille est suffisamment importante pour stocker le plus grand des enregistrements des données du dictionnaire ;

le procédé **se caractérisant par** :

- le calcul d'une moyenne des longueurs des enregistrements des données du dictionnaire ;
- le calcul de l'écart-type des longueurs des enregistrements des données du dictionnaire ;
- la détermination du seuil d'écart, le seuil d'écart indiquant un écart maximum acceptable d'une longueur d'enregistrement de données à partir de la longueur moyenne de l'enregistrement des données ;
- le calcul d'une longueur d'enregistrement des données de seuil à partir de la moyenne calculée, à partir de l'écart-type calculé et à partir du seuil d'écart déterminé ;

- le fractionnement du dictionnaire entre un dictionnaire secondaire (314) et un dictionnaire principal (310), le dictionnaire principal comprenant sélectivement ceux des enregistrements des données dont les longueurs sont inférieures ou égales à la longueur de l'enregistrement des données de seuil, le dictionnaire secondaire comprenant sélectivement ceux des enregistrements des données dont les longueurs sont supérieures à la longueur de l'enregistrement des données de seuil ;

- le stockage des enregistrements des données du dictionnaire principal dans un premier réseau d'autres éléments de la mémoire, au moyen duquel la dimension de chacun des autres éléments de la mémoire est adaptée à l'espace de la mémoire consommée par l'enregistrement des données de la longueur calculée de l'enregistrement des données de seuil ; et

- le stockage des enregistrements des données du dictionnaire secondaire dans un second réseau d'encore autres éléments de la mémoire, au moyen duquel la dimension de chacun des encore autres éléments de la mémoire est adaptée à l'espace de la mémoire consommée par l'enregistrement le plus long de tous les enregistrements des données du dictionnaire.

2. Procédé informatisé selon la revendication 1, dans lequel la détermination du seuil d'écart comprend :

- la détermination d'une pluralité de différents seuils d'écart candidats ;

- le calcul, pour chacun desdits seuils d'écart candidats, d'une longueur de l'enregistrement des données du seuil candidat à partir de la moyenne calculée, à partir de l'écart-type calculé et à partir du seuil de l'écart candidat déterminé ;

- la détermination, pour chacun desdits seuils d'écart candidats, du nombre d'enregistrements des données qui serait stocké dans un dictionnaire principal candidat et dans un dictionnaire secondaire candidat dans le cas de l'utilisation dudit seuil d'écart candidat pour fractionner le dictionnaire en dictionnaire candidat secondaire et en dictionnaire candidat principal, et le calcul de la dimension globale de la combinaison desdits dictionnaire candidat principal et dictionnaire candidat secondaire ;

- le classement des seuils d'écart candidats, au moyen duquel plus ladite dimension globale du dictionnaire candidat principal et du dictionnaire candidat secondaire calculés par ledit seuil d'écart candidat est élevée, plus le rang est bas ; et

- le choix de l'un des seuils d'écart candidats ayant attribué le rang le plus élevé en tant que seuil d'écart déterminé.

3. Procédé mis en oeuvre par ordinateur selon l'une quelconque des revendications précédentes, comprenant en outre :

- l'obtention de la longueur d'un terme de requête ;

- la détermination si la longueur obtenue est supérieure à la longueur de l'enregistrement des données de seuil calculée ;

- si la longueur obtenue est supérieure à la longueur de l'enregistrement des données de seuil calculée, la recherche sélective du terme de requête dans le dictionnaire secondaire ;

- si la longueur obtenue est inférieure ou égale à la longueur de l'enregistrement des données de seuil calculée, la recherche sélective du terme de requête dans le dictionnaire principal.

4. Procédé mis en oeuvre par ordinateur selon l'une quelconque des revendications précédentes, dans lequel tous les enregistrements des données du dictionnaire (300) sont uniques, le procédé comprenant en outre :

- la création du dictionnaire en tant que dérivé d'un vecteur d'origine des enregistrements des données, le vecteur d'origine des enregistrements des données comprenant au moins deux copies identiques du même enregistrement des données ;

- la création d'une mise en correspondance, la correspondance associant chacun des enregistrements uniques des données dans le dictionnaire à un ou à plusieurs enregistrements identiques des données dans le vecteur d'origine.

5. Procédé mis en oeuvre par ordinateur selon l'une quelconque des revendications précédentes, comprenant en outre :

- la détermination d'au moins un autre seuil d'écart, l'autre seuil d'écart étant inférieur au seuil d'écart ;

- le calcul, pour l'autre seuil d'écart, d'une autre longueur de l'enregistrement des données de seuil à partir de la moyenne calculée, à partir de l'écart-type calculé et à partir de l'autre seuil d'écart ; et

- dans lequel le fractionnement du dictionnaire comprend le fractionnement du dictionnaire en un dictionnaire secondaire, en un dictionnaire principal et en un autre dictionnaire principal,

◦ le dictionnaire secondaire comprenant sélectivement ceux des enregistrements des données dont les longueurs sont supérieures à la longueur calculée de l'enregistrement des données de seuil et inférieures ou égales à la longueur maximale de l'enregistrement des données de tous les enregistrements des données du dictionnaire,
◦ l'autre dictionnaire principal comprend sélectivement ceux des enregistrements des données dont les longueurs sont supérieures à l'autre longueur calculée de l'enregistrement des données de seuil et dont les longueurs sont inférieures ou égales à la longueur calculée de l'enregistrement des données de seuil ;
◦ le dictionnaire principal comprend sélectivement ceux des enregistrements des données dont les longueurs sont inférieures ou égales à la longueur calculée de l'autre enregistrement des données de seuil.

6.   Procédé mis en oeuvre par ordinateur selon l'une quelconque des revendications précédentes, comprenant en outre :

- le stockage des enregistrements des données du dictionnaire principal dans un premier espace contigu de la mémoire et/ou dans un premier espace de stockage non volatil contigu ; et/ou
- le stockage des enregistrements des données du dictionnaire secondaire dans un second espace contigu de la mémoire et/ou dans un second espace de stockage non volatil contigu.

7.   Procédé mis en oeuvre par ordinateur selon l'une quelconque des revendications précédentes, comprenant en outre :

- le marquage de chacun des enregistrements des données par un ID de dictionnaire séparé, l'ID du dictionnaire séparé étant indicatif du dictionnaire secondaire dans le cas où ledit enregistrement des données a été stocké dans le dictionnaire secondaire, l'ID du dictionnaire séparé étant indicatif du dictionnaire principal dans le cas où ledit enregistrement des données a été stocké dans le dictionnaire principal, chacun des marquages étant formé d'un ou de plusieurs bits ; et/ou
- le marquage de chacun des enregistrements des données contenu dans le vecteur d'origine par un ID de dictionnaire séparé, le dictionnaire comprenant simplement des enregistrements des données uniques, le vecteur d'origine étant une version du dictionnaire qui comprend les enregistrements des données identiques multiples, l'ID du dictionnaire séparé étant indicatif du dictionnaire secondaire dans le cas où ledit enregistrement des données du vecteur d'origine a été stocké dans le dictionnaire secondaire, l'ID du dictionnaire séparé étant indicatif du dictionnaire principal dans le cas où ledit enregistrement des données du vecteur d'origine a été stocké dans le dictionnaire principal, chacun des marquages étant formé d'un ou de plusieurs bits ; et/ou
- l'ajout à chacune des valeurs entières contenues dans un vecteur des entiers (318) d'au moins un extra bit, l'au moins un extra bit agissant en tant qu'identifiant pour le dictionnaire secondaire ou pour le dictionnaire principal, le dictionnaire comprenant simplement les enregistrements des données uniques qui ont été extraites à partir de toutes les valeurs de chaîne contenues dans le vecteur d'origine, le vecteur d'origine comprenant les instances d'enregistrement des données identiques multiples, chacune des valeurs entières du vecteur des entiers ayant été générée par l'application d'une fonction d'encodage des entiers à une valeur de chaîne contenue dans le dictionnaire secondaire ou principal, l'au moins un extra bit ajouté à l'une des valeurs entières étant l'indication du dictionnaire secondaire dans le cas où ladite valeur entière a été générée par la fonction d'encodage des entiers en utilisant un enregistrement des données en tant qu'entrée dans le dictionnaire secondaire, l'au moins un extra bit étant l'indication du dictionnaire principal dans le cas où ladite valeur entière a été générée par la fonction d'encodage des entiers en utilisant un enregistrement des données en tant qu'entrée dans le dictionnaire principal.

8.   Procédé mis en oeuvre par ordinateur selon l'une quelconque des revendications précédentes, comprenant en outre :

- la mise à disposition d'une séquence de chaînes, la séquence de chaînes comprenant une pluralité de valeurs de chaîne différentes et au moins deux valeurs de chaîne identiques ;
- la création du dictionnaire en tant que dérivé de la séquence de chaînes, le dictionnaire étant formé par les valeurs de chaîne uniques de la séquence des chaînes, chacune des valeurs de chaîne uniques étant l'un des enregistrements des données du dictionnaire ;
- la création d'un vecteur des entiers (318) à partir de la séquence des chaînes par :

◦ l'application d'une fonction d'encodage des entiers à chacune des chaines du dictionnaire, la fonction d'encodage des entiers étant une fonction qui génère, pour chacune des valeurs de chaine uniques du dictionnaire, une valeur entière unique respective ; et

◦ par le stockage de ladite valeur entière unique dans un ou dans plusieurs éléments du vecteur des entiers.

9. Procédé mis en oeuvre par ordinateur selon la revendication 8, comprenant en outre :

- la réception d'une demande comprenant un terme de requête ;
- l'application de la fonction d'encodage des entiers dans le terme de requête, au moyen de laquelle une valeur entière de requête est créée ;
- la réalisation d'une recherche de la valeur entière de requête dans le vecteur des entiers ;
- l'identification de l'une ou de plusieurs valeurs entières correspondantes dans le vecteur des entiers, chacune des valeurs entières correspondantes correspondant à la valeur entière de requête ; et
- le renvoi du nombre des une ou plusieurs valeurs de chaîne correspondantes identifiées.

10. Procédé mis en oeuvre par ordinateur selon les revendications 8 ou 9, comprenant en outre :

- la détermination du nombre de la taille du bloc, le nombre de la taille du bloc étant un entier ;
- le fractionnement logique du vecteur des entiers après chacune des séquences continues du nombre déterminé de la taille du bloc des valeurs entières, au moyen duquel est créé une pluralité de blocs logiques du vecteur des entiers ;
- la création d'un vecteur d'encodage de bloc (322), le vecteur d'encodage de bloc comprenant un élément d'encodage pour chacun desdits blocs logiques, chacun des éléments d'encodage ayant été respectivement attribué à l'un des blocs logiques) ;
- pour chacun des blocs logiques créé, la détermination du type de bloc, le type de bloc étant l'un parmi :

◦ un bloc principal, dans lequel toutes les valeurs entières contenues dans un bloc principal ont été créées à partir de l'une des valeurs de chaîne qui était stockée dans le dictionnaire principal ; ou
◦ un bloc secondaire, dans lequel toutes les valeurs entières contenues dans le bloc secondaire ont été créées à partir de l'une des valeurs de chaîne qui était stockée dans le dictionnaire secondaire ; ou
◦ un bloc mixte, dans lequel au moins une première parmi les valeurs entières contenues dans le bloc mixte a été créée à partir de l'une des valeurs de chaîne qui était stockée dans le dictionnaire secondaire et où au moins une seconde parmi les valeurs entières contenues dans ledit bloc mixte a été créée à partir de l'une des valeurs de chaîne qui était stockée dans le dictionnaire principal ;

- pour chacun des blocs logiques créés, le stockage de l'ID du type de bloc déterminé dudit bloc logique dans celui des éléments d'encodage attribué audit bloc logique ;
- l'obtention de la longueur du terme de requête pour déterminer si ladite longueur obtenue est supérieure à la longueur calculée de l'enregistrement des données de seuil ;
- si la longueur obtenue est supérieure à longueur calculée de l'enregistrement des données de seuil, le choix du type de bloc principal en tant que type à enjambement ;
- si la longueur obtenue est inférieure ou égale à longueur calculée de l'enregistrement des données de seuil, le choix du type de bloc secondaire en tant que type à enjambement ;
- la réalisation d'une recherche de la valeur entière de requête dans le vecteur des entiers, au moyen de laquelle est effectué l'enjambement de toutes les valeurs entières contenues dans un bloc logique du type à enjambement.

11. Procédé mis en oeuvre par ordinateur selon la revendication 10,

- dans lequel les types de bloc dans le vecteur d'encodage de bloc sont précisés sous la forme d'un nombre de bits prédéfini,
- dans lequel le type de bloc choisi en tant que type à enjambement est précisé par le nombre de bits prédéfini ;
- dans lequel l'enjambement des valeurs entières contenues dans un bloc logique du type à enjambement comprend l'évaluation du type à enjambement choisi dans les types de bloc au moyen d'une recherche linéaire à l'intérieur du vecteur d'encodage de bloc.

12. Procédé mis en oeuvre par ordinateur selon les revendications 10 ou 11, dans lequel la détermination du nombre de la taille du bloc comprend :

- la détermination d'une pluralité de nombres candidats de la taille du bloc ;
- pour chacun des nombres candidats de la taille du bloc : le fractionnement logique du vecteur des entiers pour créer une pluralité de blocs logiques comprenant ledit nombre candidat de la taille du bloc des valeurs entières, la génération du vecteur respectif d'encodage du bloc et la détermination du type de bloc pour chacun desdits blocs logiques créés dudit vecteur d'encodage du bloc ;

- pour chacun des nombres candidats de la taille du bloc, le calcul du coût de la réalisation, dans lequel le coût de la réalisation est calculé comme suit : BEV_Performance_Cost = (Total_Major_Dictionary_Blocks + Total_Mixed_Dictionary_Blocks) * Major_Dictionary_Count + (Total_Minor_Dictionary_Blocks + Total_Mixed_Dictionary_Blocks) * Minor_Dictionary_Count, ou en tant que dérivé de ladite valeur BEV_Performance_Cost,

   ◦ où BEV_Performance_Cost est le coût de la réalisation ;
   ◦ où Total_Major_Dictionary_Blocks est le nombre total de blocs logiques de type bloc principal qui est obtenu lorsque l'on utilise ledit nombre de la taille de bloc candidat pour le fractionnement logique ;
   ◦ où Total_Mixed_Dictionary_Blocks est le nombre total de blocs logiques de type de bloc mixte qui est obtenu lorsque l'on utilise ledit nombre de la taille de bloc candidat pour le fractionnement logique ;
   ◦ où Total_Minor_Dictionary_Blocks est le nombre total de blocs logiques de type bloc secondaire qui est obtenu lorsque l'on utilise ledit nombre de la taille de bloc candidat pour le fractionnement logique ;
   ◦ où Major_Dictionary_Count est le nombre total d'enregistrements des données du dictionnaire principal qui est obtenu lorsque l'on utilise ledit nombre de la taille de bloc candidat pour le fractionnement logique ;
   ◦ où Minor_Dictionary_Count est le nombre total d'enregistrements des données du dictionnaire secondaire qui est obtenu lorsque l'on utilise ledit nombre de la taille de bloc candidat pour le fractionnement logique ;

- le classement des coûts de réalisation calculés, où plus les coûts de réalisation sont faibles, plus le rang est élevé ; et
- l'utilisation du nombre de la taille de bloc candidat dont les coûts de réalisation calculés ont le rang le plus élevé ainsi que le nombre de la taille de bloc déterminé.

13. Procédé mis en oeuvre par ordinateur selon l'une quelconque des revendications 10 à 12,

   - dans lequel la détermination du nombre de la taille de bloc est exécutée pour chacun de la pluralité des seuils d'écart candidats, au moyen duquel pour chacun des seuils d'écart candidats, est calculée la taille totale selon la revendication 2 ; et
   - dans lequel pour chacun des seuils d'écart candidats, les coûts de réalisation sont calculés pour chacun de la pluralité des nombres de la taille de bloc candidats, où les coûts de réalisation sont calculés de préférence selon la revendication 12, par ce fait est calculé un résultat des coûts combinés pour chacune des pairs évaluées du nombre de la taille de bloc candidat et du seuil d'écart candidat ;
   - par lequel plus les coûts de réalisation informatiques calculés pour un nombre de la taille de bloc candidat particulier sont élevés, plus le résultat des coûts combinés sont élevés ;
   - par lequel plus ladite taille totale du dictionnaire principal et du dictionnaire secondaire candidats calculée pour un seuil d'écart candidat est importante, plus le résultat des coûts combinés est élevé ; et
   - dans lequel le procédé comprend en outre le choix de la paire du seuil d'écart candidat et du nombre de la taille de bloc candidat correspondant au résultat des coûts combinés le plus faible.

14. Support de stockage non transitoire comprenant des instructions interprétables par ordinateur, au moyen duquel les instructions, lorsqu'elles sont exécutées par un processeur, amènent le processeur à exécuter un procédé selon l'une quelconque des revendications précédentes.

15. Système informatique (602) comprenant un processeur et une mémoire principale, le processeur étant configuré pour :

   - mettre à disposition un dictionnaire (300) comprenant une pluralité d'enregistrements de données, chacun desdits enregistrements des données étant stocké dans un élément de mémoire de la mémoire principale, au moyen duquel la taille de chacun desdits éléments de mémoire est suffisamment importante pour stocker celui des enregistrements des données du dictionnaire qui est le plus long ;

   et le système étant **caractérisé par**

   - le calcul d'une moyenne et de l'écart-type des longueurs des enregistrements des données du dictionnaire ;
   - la détermination du seuil d'écart, le seuil d'écart indiquant l'écart maximum acceptable dans une longueur de l'enregistrement des données à partir de la longueur moyenne de l'enregistrement des données ;

- le calcul d'une longueur de l'enregistrement des données de seuil à partir de la moyenne calculée, à partir de l'écart-type calculé et à partir du seuil d'écart déterminé ;

- le fractionnement du dictionnaire en un dictionnaire secondaire (314) et en un dictionnaire principal (310), le dictionnaire principal comprenant sélectivement ceux des enregistrements des données dont les longueurs sont inférieures ou égales à la longueur de l'enregistrement des données du seuil, le dictionnaire secondaire comprenant sélectivement ceux des enregistrements des données dont les longueurs sont supérieures à la longueur de l'enregistrement des données du seuil ;

- le stockage des enregistrements des données du dictionnaire principal dans un premier réseau d'autres éléments de mémoire, au moyen duquel la taille de chacun des autres éléments de mémoire est adaptée à l'espace de la mémoire consommée par un enregistrement des données de la longueur calculée de l'enregistrement des données du seuil ; et

- le stockage des enregistrements des données du dictionnaire secondaire dans un second réseau d'encore autres éléments de mémoire, au moyen duquel la dimension de chacun des encore autres éléments de mémoire est adaptée à l'espace de la mémoire consommée par l'enregistrement le plus long de tous les enregistrements des données du dictionnaire.

*100*

*104*

CLIENT

APPLICATION — *108*

TWO-TIERED
ARCHITECTURE

*112*

*120*

SERVER

DATABASE — *116*

## FIG. 1A

*150*

*104*

CLIENT

USER INTERFACE — *154*

*162*

*120*

PRESENTATION
SERVERS

PRESENTATION
LAYER — *158*

MULTI-TIERED
ARCHITECTURE

*170*

BUSINESS LAYER
SERVERS

BUSINESS
LAYER — *166*

*178*

DATABASE
SERVERS

DATABASE — *174*

## FIG. 1B

| TABLE NAME | COLUMN NAME | DICTIONARY START ADDRESS | ENCODING INTEGER LENGTH (IN BITS) | WIDTH OF THE STRING COLUMN | TOTAL NUMBER OF STRINGS IN THE DICTIONARY |
|---|---|---|---|---|---|
| SUPPLIERS | CITY | 000XXX01 | 20 | 100 | 1000000 |

## FIG. 2A

| PARAMETER | VALUE |
|---|---|
| TOTAL NUMBER OF RECORDS | 932000 |
| LONGEST STRING LENGTH | 91 CHARACTERS |
| SPECIFIED COLUMN WIDTH | 91 CHARACTERS = 91 BYTES |
| AVERAGE LENGTH OF STRINGS | 10.16 CHARACTERS ~ 11 BYTES |
| STANDARD DEVIATION IN LENGTH OF STRINGS | 4.20 CHARACTERS |
| TOTAL DICTIONARY SIZE | 932000 * 91 BYTES = 80.88 MB |
| DICTIONARY PERFORMANCE (CONSIDERING A 2MB/ms/CORE PERFORMANCE) | 80.88 / 2 = 40.44 ms |
| TOTAL SPACE WASTED | 80.88 MB - (11 BYTES * 932000 MILLION) = 80.88 - 9.78 MB = 71.10 MB |

## FIG. 2B

**FIG. 3A**

**FIG. 3B**

**FIG. 3C**

| TABLE NAME | COLUMN NAME | DICTIONARY START ADDRESS | ENCODING INTEGER LENGTH (IN BITS) | WIDTH OF STRING COLUMN (IN BITS) | COUNT OF STRINGS |
|---|---|---|---|---|---|
| SUPPLIERS | CITY | 000XXX01 | 20 | 25 | 997000 |
| SUPPLIERS | CITY | 00022222 | 20 | 100 | 3000 |

**FIG. 4**

*FIG. 5A*

*FIG. 5B*

600 ⟍

┌─ 602

PROCESSING SYSTEM

┌─ 604

OPERATING SYSTEM

┌─ 606

USER INTERFACE MODULE

┌─ 610

SPLIT CONDITION
DETERMINATION MODULE

┌─ 614

BLOCK ENCODING VECTOR
GENERATOR MODULE

┌─ 618

SPLIT DICTIONARY
GENERATOR MODULE

┌─ 622

QUERY EXECUTION MODULE

*FIG. 6*

700

DECIDING THE SPLIT CONDITION

704

CALCULATE THE MEAN AND STANDARD DEVIATION IN LENGTHS FOR THE STRINGS OF THE DICTIONARY

708

FIND THE PERCENTAGE OF POPULATION WHICH FALLS IN EACH CATEGORY OF $\mu + K * \sigma$ (K = 1,2,3...)

712

CALCULATE THE MEMORY AND PERFORMANCE ADVANTAGES FOR THE DIFFERENT VALUES OF 'K'

716

FIND THE OPTIMUM 'K' VALUE (FOR THE MAXIMUM MEMORY AND PERFORMANCE LEVEL)

720

SIMULATE A DICTIONARY SPLIT ON THE SELECTED 'K' VALUE AND GENERATE THE BLOCK ENCODING VECTOR FOR THE ATTRIBUTE VECTOR (BASED ON THE SIMULATED SPLIT)

724

MINIMUM NUMBER OF MIXED DICTIONARY BLOCKS AND EQUAL NUMBER OF MAJOR AND MINOR DICTIONARY BLOCKS?

YES

NO

728

SHIFT THE 'K' VALUE

FIG. 7

800

DECIDING THE SPLIT CONDITION
(AV SCAN PERFORMANCE)

↓

804

INITIALIZE
SPLIT_LENGTH = START_SPLIT_LENGTH
MAX_SPLIT_LENGTH = END_SPLIT_LENGTH
MAX_BLOCK_SIZE = END_BLOCK_SIZE
MINIMUM_COST = MAX_LONG_NUMBER

↓

808

SPLIT_LENGTH =
MAX_SPLIT_LENGTH?  — YES → ◉

↓ NO

812

INITIALIZE BLOCK_SIZE = START_BLOCK_SIZE

↓

816

BLOCK_SIZE =
MAX_BLOCK_SIZE?  — YES →  818  INCREMENT SPLIT_LENGTH BY DELTA

↓ NO

820

NEW_COST = COMPUTE BEV
PERFORMANCE COST

↓

824

NEW_COST <
MINIMUM_COST?

832  INCREMENT BLOCK_SIZE BY DELTA  ← NO —

↓ YES

828

MINIMUM_COST = NEW_COST

*FIG. 8*

49

900

| D | I | I | I | I | I | | | | I |
|---|---|---|---|---|---|---|---|---|---|
| 0 | 0 | 1 | 2 | 3 | 4 | ... | ... | ... | 20 |

## FIG. 9

1000

```
           ┌─────────────────────────┐
           │   CREATING THE BEV       │
           └─────────────────────────┘
                        │
                        ▼                        ┌─ 1004
   ┌──────────────────────────────────────────────────────┐
   │                    INITIALIZE                          │
   │   MAX_AV_SIZE = END_AV_LENGTH                          │
   │   BEV_BLOCK_SIZE = CALCULATED_BLOCK_SIZE              │
   │   MAX_BEV_SIZE = MAX_AV_SIZE / BEV_BLOCK_SIZE         │
   │   BEV_ITERATOR = 0, BEV = NEW_VECTOR [MAX_BEV_SIZE]   │
   │ IS_MAJOR_BLOCK = 01, IS_MINOR_BLOCK = 10, IS_MIXED_BLOCK = 11 │
   └──────────────────────────────────────────────────────┘
```

INITIALIZE
MAX_AV_SIZE = END_AV_LENGTH
BEV_BLOCK_SIZE = CALCULATED_BLOCK_SIZE
MAX_BEV_SIZE = MAX_AV_SIZE / BEV_BLOCK_SIZE
BEV_ITERATOR = 0, BEV = NEW_VECTOR [MAX_BEV_SIZE]
IS_MAJOR_BLOCK = 01, IS_MINOR_BLOCK = 10, IS_MIXED_BLOCK = 11

1008

YES ← BEV_ITERATOR = MAX_BEV_SIZE?

1020 — INCREMENT BEV_ITERATOR BY 1

NO

1012 — ALL ELEMENTS OF THE BEV_BLOCK IN AV BELONG TO MAJOR DICTIONARY?

YES → 1016 — BEV [BEV_ITERATOR] = IS_MAJOR_BLOCK

NO

1024 — ALL ELEMENTS OF THE BEV_BLOCK IN AV BELONG TO MINOR DICTIONARY?

YES → 1028 — BEV [BEV_ITERATOR] = IS_MINOR_BLOCK

NO — 1032 — BEV [BEV_ITERATOR] = IS_MIXED_BLOCK

## FIG. 10

*1100*

CREATE SPLIT DICTIONARIES

*1104*

INITIALIZE
OPTIMAL_SPLIT_LENGTH = 0, HAS_IMPROVED = FALSE, DELTA = 1

*1108*

CALCULATE THE COMPRESSION RATIO FOR L =
$\mu + K * \sigma$ (WITH K = 3)

*1112*

DECREASE L BY DELTA AND RE-COMPUTE
THE COMPRESSION RATIO

*1116*

COMPRESSION
RATIO INCREASES?    —YES→    OPTIMAL_SPLIT_LENGTH = L,
HAS_IMPROVED = TRUE    *1120*

NO

*1124*

YES ←    HAS_IMPROVED = TRUE?

NO

*1132*

RE-INITIALIZE L = $\mu + K * \sigma$ (WITH K = 3)

*1136*

INCREASE L BY DELTA AND RE-COMPUTE
THE COMPRESSION RATIO

*1140*

COMPRESSION
RATIO INCREASES?    —YES→    OPTIMAL_SPLIT_LENGTH = L,
HAS_IMPROVED = TRUE    *1144*

NO

*1128*

CREATE THE MAJOR AND MINOR
DICTIONARIES BY SPLITTING THE
ORIGINAL DICTIONARY AT
OPTIMAL_SPLIT_LENGTH    ←YES    HAS_IMPROVED = TRUE?    *1148*

NO

*1152*

OPTIMAL_SPLIT_LENGTH =
$\mu + K * \sigma$ (WITH K = 3)

*FIG. 11*

*1200*

CREATE SPLIT DICTIONARIES

*1204*
INITIALIZE
OPTIMAL_SPLIT_LENGTH = 0
SPLIT_LENGTH = START_SPLIT_LENGTH
MAX_SPLIT_LENGTH = END_SPLIT_LENGTH
MAX_BLOCK_SIZE = END_BLOCK_SIZE

*1212*
CREATE THE MAJOR AND MINOR
DICTIONARIES BY SPLITTING THE
ORIGINAL DICTIONARY AT
OPTIMAL_SPLIT_LENGTH

*1208*
SPLIT_LENGTH = MAX_SPLIT_LENGTH?   — YES

NO

*1216*
INITIALIZE BLOCK_SIZE = START_BLOCK_SIZE

*1220*
BLOCK_SIZE = MAX_BLOCK_SIZE?   — YES

*1240*
INCREMENT SPLIT_LENGTH
BY DELTA

NO

*1224*
NEW_COST = COMPUTE BEV
PERFORMANCE COST

*1236*
INCREMENT BLOCK_SIZE
BY DELTA   — NO

*1228*
NEW_COST <
MINIMUM_COST?

YES

*1232*
MINIMUM_COST = NEW_COST
OPTIMAL_SPLIT_LENGTH = SPLIT_LENGTH

*FIG. 12*

1300 ⟶

1304

QUERY:
SELECT COUNT (*) FROM TABLE_NAME WHERE
COLUMN_NAME = 'PARAMETER'

1308

CALCULATE THE LENGTH OF THE
QUERY 'PARAMETER'

1316

SELECT THE MAJOR DICTIONARY
AS THE SEARCH SPACE

YES

1312

'PARAMETER'
LENGTH <
CUT_LENGTH?

NO

1320

SELECT THE MINOR DICTIONARY
AS THE SEARCH SPACE

1324

CHECK THE MASTER/META DATA FOR 'TABLE_NAME' TO
RETRIEVE THE START ADDRESS OF THE SELECTED
(MAJOR/MINOR) DICTIONARY

1328

SEARCH THE 'PARAMETER' IN THE SELECTED
DICTIONARY TABLE AND CALCULATE ITS MEMORY OFFSET
FROM THE START ADDRESS OF THE DICTIONARY (THIS
MEMORY OFFSET IS EQUIVALENT TO THE INTEGER ID USED
IN THE ATTRIBUTE VECTOR)

1332

SELECT AN ELEMENT FROM THE BLOCK
ENCODING VECTOR

A

FIG. 13A

A

BLOCK ENCODING
VECTOR ELEMENT VALUE
CORRESPONDS TO SELECTED
DICTIONARY? — 1336

YES

NO

1340 — SEARCH THE INTEGER ID IN THE
ATTRIBUTE VECTOR CLUSTER

SKIP THE ATTRIBUTE
VECTOR CLUSTER — 1348

BLOCK
ENCODING VECTOR SCAN
COMPLETE? — 1344

YES

NO

A

*FIG. 13B*

1400 —▸

QUERY:
SELECT COUNT (*) FROM TABLE_NAME WHERE
COLUMN_NAME LIKE '%PARAMETER%' ⌐ 1404

SEARCH BOTH THE MAJOR AND THE MINOR DICTIONARY
TABLES TO MATCH '%PARAMETER%' AND CREATE AN
ARRAY OF MEMORY OFFSETS (INTEGER IDs) TO STORE
EACH MATCHED STRING ⌐ 1408

MATCHED STRINGS
BELONG TO ONLY ONE OF THE
DICTIONARIES? ⌐ 1412

YES

NO

SELECT THE APPROPRIATE (MAJOR/MINOR)
DICTIONARY AS THE SEARCH SPACE ⌐ 1416

SELECT BOTH DICTIONARIES
AS THE SEARCH SPACE ⌐ 1428

CHECK THE MASTER/META DATA FOR 'TABLE_NAME' TO
RETRIEVE THE START ADDRESS OF THE APPROPRIATE
(MAJOR/MINOR) DICTIONARY ⌐ 1420

CHECK THE MASTER/META DATA FOR 'TABLE_NAME' TO
RETRIEVE THE START ADDRESS OF BOTH DICTIONARIES ⌐ 1432

SELECT AN ELEMENT FROM THE BLOCK
ENCODING VECTOR ⌐ 1424

SELECT AN ELEMENT FROM THE BLOCK
ENCODING VECTOR ⌐ 1436

B

C

FIG. 14A

B

BLOCK ENCODING
VECTOR ELEMENT VALUE
CORRESPONDS TO SELECTED
DICTIONARY? — *1440*

YES

NO

*1444* — SEARCH THE INTEGER ID IN THE ATTRIBUTE VECTOR CLUSTER

SKIP THE ATTRIBUTE VECTOR CLUSTER — *1452*

BLOCK
ENCODING VECTOR SCAN
COMPLETE? — *1448*

YES

NO

B

*FIG. 14B*

FIG. 14C

FIG. 15A

FIG. 15B

FIG. 15C

**FIG. 15D**

**FIG. 15E**

*FIG. 16*

**EP 2 881 870 B1**

**REFERENCES CITED IN THE DESCRIPTION**

**Patent documents cited in the description**

• US 20130151567 A1, Ellison Lawrence J